(19) Europäisches Patentamt
European Patent Office
Office européen des brevets

(11) **EP 2 557 600 A1**

# (12) EUROPEAN PATENT APPLICATION
published in accordance with Art. 153(4) EPC

(43) Date of publication:
**13.02.2013 Bulletin 2013/07**

(21) Application number: **11766017.5**

(22) Date of filing: **08.04.2011**

(51) Int Cl.:
**H01L 31/042** (2006.01)   **C09K 11/06** (2006.01)

(86) International application number:
**PCT/JP2011/058933**

(87) International publication number:
**WO 2011/126117 (13.10.2011 Gazette 2011/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.04.2010 JP 2010090350**

(71) Applicant: **Hitachi Chemical Company, Ltd. Tokyo 163-0449 (JP)**

(72) Inventors:
• **OKANIWA, Kaoru**
  **Tsukuba-shi**
  **Ibaraki 300-4247 (JP)**
• **YAMASHITA, Takeshi**
  **Tsukuba-shi**
  **Ibaraki 300-4247 (JP)**
• **SAWAKI, Taku**
  **Tsukuba-shi**
  **Ibaraki 300-4247 (JP)**

(74) Representative: **HOFFMANN EITLE Patent- und Rechtsanwälte Arabellastrasse 4 81925 München (DE)**

(54) **WAVELENGTH-CONVERTING RESIN COMPOSITION FOR SOLAR CELL, AND SOLAR CELL MODULE**

(57)    A wavelength-converting resin composition for a photovoltaic cell, comprising: a fluorescent substance having a maximum absorption wavelength in an absorbance spectrum of which being $\lambda_{max}$ (nm); resin particles; and a dispersion medium resin,

wherein a value of $A_1 (\lambda)$, which is represented by the following Equation 1, at the maximum absorption wavelength $\lambda_{max}$ (nm) is $3.0 \times 10^{-4}$ (O. D. /$\mu$m) or less in a case in which:

an intensity of transmitted light that is obtained as a result of incident light having a light intensity of $I_0 (\lambda)$ at a wavelength $\lambda$ (nm) having passed through a resin film in a thickness direction of the resin film, the resin film being formed from the resin composition and having a thickness of t ($\mu$m), is defined as $I (\lambda)$; and

an intensity of transmitted light that is obtained as a result of the incident light having passed through a reference resin film in a thickness direction of the reference resin film, the reference resin film being formed from a reference resin composition obtained by excluding the fluorescent substance and the resin particles from the resin composition, and having a thickness of $t_{ref}$ ($\mu$m), is defined as $I_{ref} (\lambda)$.

$$\text{Equation 1:} \qquad A_1(\lambda) = \{\log(I_0(\lambda)/I(\lambda))\}/t - \log\{(I_0(\lambda)/I_{ref}(\lambda))\}/t_{ref}$$

EP 2 557 600 A1

FIG. 1

**Description**

Technical Field

The invention relates to a wavelength-converting resin composition for a photovoltaic cell and a photovoltaic cell module.

Background Art

Conventional crystalline silicone photovoltaic cell modules have a configuration in which reinforced glass is used as a protective glass (also called a cover glass) which locates at its surface in view of importance of impact resistance and one surface thereof is provided with concavities and convexities formed by embossing processing in view of enhancing its adhesiveness to a sealant (which is usually a resin containing an ethylene-vinyl acetate copolymer as its main component and is also called a filler). The concavities and convexities are formed on the inner side, and the surface of the photovoltaic cell module is smooth (there are cases in which the outer side is further provided with the concavities and convexities in view of increasing the introduction rate of solar radiation). Further, a photovoltaic cell, a sealant for protecting and sealing a tab line, and a back film are provided under the protective glass.

Various suggestions for improving power generation efficiency of a photovoltaic cell have been made. For example, Japanese Patent Application Laid-Open (JP-A) Nos. 2000-328053 and 2001-352091 and the like suggest a technique which provides, on a light-receiving surface of a photovoltaic cell, a layer which emits a light which is within a wavelength range which contributes significantly to power generation by converting, by using a fluorescent substance, the wavelength of a light in the ultraviolet region or in the infrared region which contributes less to power generation in the solar radiation spectrum.

Disclosure of Invention

Problems to be Solved by the Invention

The suggestions described in JP-A Nos. 2000-328053 and 2001-352091, in which the wavelength of a light in a wavelength region that contributes less to power generation is converted to a light in a light in a wavelength region that contributes significantly to power generation, teaches containing fluorescent substances in a wavelength converting layer. However, fluorescent substances generally have large refractive indices. Further, the shape of the fluorescent substances may cause scattering of incident solar radiation when it passes through a wavelength converting film. Therefore, there are cases in which the proportion of solar radiation that does not sufficiently reach the photovoltaic cell and then does not contribute to power generation increases.

An object of the invention is to provide a wavelength-converting resin composition which can configure a photovoltaic cell module which has excellent power generation efficiency and a photovoltaic cell module provided with a light transmission layer containing the wavelength-converting resin composition.

MEANS FOR SOLVING THE PROBLEMS

As a result of an intensive investigation to address the object, the present inventors have found that in a conventional wavelength converting layer, there are cases in which the scattering of light occurs because a fluorescent substance, which has a refractive index which is different from that of a medium and has a large particle diameter, is dispersed in a transparent dispersion medium resin, and as a result thereof, the proportion of generated electric power with respect to incident solar radiation (power generation efficiency) is not increased, even if the wavelength conversion layer converts light in the ultraviolet region to light in the visible region. It has been further surprisingly found that there are cases in which the wavelength conversion function adversely affects a conversion efficiency of a photovoltaic cell in cases in which scattering of light in the ultraviolet region can occur, even if is no light loss such as the scattering of light occurs in the visible region. Based on these findings, the present inventors found a technique which works, in a wavelength-converting resin composition which converts light which is in a wavelength region contributing less to power generation among incident solar radiation to light which is in a wavelength region contributing much to power generation, as an evaluation standard which enables efficient introduction of light into a photovoltaic cell with less light scattering, to complete the invention.

That is, the invention is as follows.

<1> A wavelength-converting resin composition for a photovoltaic cell, comprising: a fluorescent substance having a maximum absorption wavelength in an absorbance spectrum of $\lambda_{max}$ (nm); resin particles; and a dispersion medium resin,

wherein a value of $A_1(\lambda)$, which is represented by the following Equation 1, at the maximum absorption wavelength $\lambda_{max}$ (nm) is $3.0\times10^{-4}$ (O. D. $/\mu$m) or less in a case in which:

an intensity of transmitted light that is obtained as a result of incident light having a light intensity of $I_0(\lambda)$ at a wavelength $\lambda$, (nm) having passed through a resin film in a thickness direction of the resin film, the resin film being formed from the resin composition and having a thickness of t ($\mu$m), is defined as $I(\lambda)$; and

an intensity of transmitted light that is obtained as a result of the incident light having passed through a reference resin film in a thickness direction of the reference resin film, the reference resin film being formed from a reference resin composition obtained by excluding the fluorescent substance and the resin particles from the resin composition, and having a thickness of $t_{ref}$ ($\mu$m), is defined as $I_{ref}(\lambda)$:

$$\text{Equation 1:} \qquad A_1(\lambda) = \{\log(I_0(\lambda)/I(\lambda))\}/t - \log\{(I_0(\lambda)/I_{ref}(\lambda))\}/t_{ref}.$$

<2> The wavelength-converting resin composition for a photovoltaic cell of <1>, wherein the fluorescent substance is encapsulated in the resin particles.

<3> The wavelength-converting resin composition for a photovoltaic cell of <1> or <2>, wherein the fluorescent substance is a rare earth complex comprising an organic ligand.

<4> A photovoltaic cell module, comprising a light transmitting layer including the wavelength-converting resin composition for a photovoltaic cell of any one of <1> to <3>.

<5> A method for evaluating a wavelength-converting resin composition for a photovoltaic cell, the method comprising evaluating a wavelength conversion efficiency based on a value of $A_1(\lambda)$, which is represented by the following Equation 1, at a maximum absorption wavelength $\lambda_{max}$ (nm), in a case in which:

an intensity of transmitted light that is obtained as a result of incident light having a light intensity of $I_0(\lambda)$ at a wavelength $\lambda$ (nm) having passed through a resin film in a thickness direction of the resin film, the resin film being formed from the resin composition and having a thickness of t ($\mu$m), is defined as $I(\lambda)$; and

an intensity of transmitted light that is obtained as a result of the incident light having passed through a reference resin film in the thickness direction of the reference resin film, the reference resin film being formed from a reference resin composition obtained by excluding the fluorescent substance and the resin particles from the resin composition, and having a thickness of $t_{ref}$ ($\mu$m), is defined as $I_{ref}(\lambda)$:

$$\text{Equation 1:} \qquad A_1(\lambda) = \{\log(I_0(\lambda)/I(\lambda))\}/t - \log\{(I_0(\lambda)/I_{ref}(\lambda))\}/t_{ref}.$$

Effects of the invention

According to the invention, a wavelength-converting resin composition which can configure a photovoltaic cell module which has an excellent power generation efficiency and a photovoltaic cell module which is provided with a light transmission layer containing the wavelength-converting resin composition may be provided.

BRIEF DESCRIPTION OF DRAWINGS

Fig. 1 is a graph showing an example of a relationship between the value of $A_1(\lambda)$ of the invention at the wavelength 350 nm and a power generation efficiency of a photovoltaic cell.

Fig. 2 is a graph showing an example of relationships between wavelength of incident light and the values of $A_1(\lambda)$ with respect to wavelength-converting resin compositions of Examples of the invention and Comparative examples.

Fig. 3 is a graph showing an example of a relationship between wavelength of incident light and the values of $A_1(\lambda)$ with respect to wavelength-converting resin compositions of Examples of the invention and Comparative examples.

Fig. 4 is a graph showing an example of an excitation spectrum and an emission spectrum of a fluorescent substance of Examples of the invention.

Fig. 5 is a graph showing an example of an absorbance spectrum and an emission spectrum of a fluorescent substance dispersed in a dispersion medium resin of Examples of the invention.

Fig. 6 is a graph showing an example of relationships between an average of the value of $A_1(\lambda)$ of the invention at the wavelength of from 350 nm to 450 nm and a power generation efficiency of a photovoltaic cell of Examples of the invention.
Fig. 7 is a graph showing an example of relationships between an in-line transmittance in the visible region and a power generation efficiency of a photovoltaic cell of Comparative examples of the invention.
Fig. 8 is a graph showing an example of relationships between integrated emission intensity and a power generation efficiency of a photovoltaic cell of Comparative examples of the invention.

BEST MODE FOR CARRYING OUT THE INVENTION

In the specification, the expression of "from ... to..." refers to a range in which the numerical value shown at the former thereof is included as its minimum value and the numerical value shown at the latter thereof is included as its maximum value.

<Wavelength-converting resin composition for Photovoltaic cell>

The wavelength-converting resin composition for a photovoltaic cell of the invention comprises: a fluorescent substance having a maximum absorption wavelength in an absorbance spectrum of $\lambda_{max}$ (nm); resin particles; and a dispersion medium resin. A value of $A_1(\lambda)$, which is represented by the following Equation 1, at the maximum absorption wavelength $X_{max}$ (nm) is 0.0003 (O. D. /$\mu$m) or less in a case in which: an intensity of transmitted light is obtained as a result of incident light having a light intensity of $I_0(\lambda)$ at a wavelength $\lambda$, (nm) having passed through a resin film in a thickness direction of the resin film, the resin being formed from the resin composition and having a thickness of t ($\mu$m), is defined as $I(\lambda)$; and an intensity of transmitted light that is obtained as a result of the incident light having passed through a reference resin film in a thickness direction of the reference film, the reference resin film being formed from a resin composition obtained by excluding the fluorescent substance and the resin particles from the resin composition, and having a thickness of $t_{ref}$ ($\mu$m), is defined as $I_{ref}(\lambda)$.

$$\text{Equation 1:} \qquad A_1(\lambda) = \{\log(I_0(\lambda)/I(\lambda))\}/t - \log\{(I_0(\lambda)/I_{ref}(\lambda))\}/t_{ref}$$

A power generation efficiency of a photovoltaic cell having a light transmitting resin layer formed from a wavelength-converting resin composition for a photovoltaic cell including a fluorescent substance, resin particles, and a dispersion medium resin is increased by forming the wavelength-converting resin composition to have a configuration which provides the value of $A_1(\lambda)$, which is represented by Equation 1, at the maximum absorption wavelength $\lambda_{max}$ (nm) in an absorbance spectrum of $3.0 \times 10^{-4}$ (O.D. /$\mu$m) or less. On the other hand, in a case in which the value of $A_1(\lambda)$, which is represented by Equation 1, at the maximum absorption wavelength $\lambda_{max}$ (nm) in an absorbance spectrum exceeds $3.0 \times 10^{-4}$ (O. D. /$\mu$m), the power generation efficiency may not only fail to increase but also may decrease.
This can be understood because, for example, light which is in a wavelength region contributing less to photovoltaic power generation among incident solar radiation which enters the photovoltaic cell is converted to light which is in a wavelength region contributing much to power generation, and at the same time, solar radiation can be used efficiently and stably for power generation with suppressing scattering of solar radiation.
The value of $A_1(\lambda)$ at the wavelength $\lambda_{max}$ (nm), that is $3.0 \times 10^{-4}$ (O. D. /$\mu$m) or less in the invention, is preferably $2.5 \times 10^{-4}$ (O. D. /$\mu$m) or less, and more preferably $2.0 \times 10^{-4}$ (O. D. /$\mu$m) or less, in view of the conversion efficiency of a photovoltaic cell.
The value of $A_1(\lambda)$ is measured in the invention by using a solar simulator grating spectroradiometer LS-100 manufactured by Eko Instruments Co., Ltd. and a solar simulator WXS-155S-10, AM 1.5G manufactured by Wacom Electric Co., Ltd..
Specifically, a sample for evaluation is placed on a detection unit of the grating spectroradiometer LS-100 and radiation is provided thereto by using the solar simulator WXS-155S-10, AM 1.5G manufactured by Wacom Electric Co., Ltd. to obtain the intensity spectrum $I(\lambda)$. Further, the intensity spectrum of blank, $I_0(\lambda)$, is obtained without placing anything on the detection unit of the LS-100. Further, a reference sample is placed on the detection unit of the LS-100, and the intensity spectrum of the reference sample, $I_{ref}(\lambda)$, is obtained. The value of $A_1(\lambda)$ is calculated according to Equation 1 using the thus-measured intensity spectra.
The absorbance spectrum of the fluorescent substance may be measured by a usual method by using a spectrophotometer (such as U-3300 manufactured by Hitachi High-Technologies Corporation or V-570 manufactured by JASCO Corporation).
The thickness of the resin film may be measured by using a digital micrometer.
Since the power generation efficiency of a photovoltaic cell at the wavelength-converting resin composition is evaluated in the invention based on the degree of scattering of light which is in a wavelength region contributing less to photovoltaic power generation, evaluation may be performed by using, in place of the value of $A_1 (\lambda)$ at the $\lambda_{max}$, a value which corresponds therewith. Specific examples thereof include the following methods.

The conversion efficiency obtained when a photovoltaic cell is formed may be also evaluated in the invention by using, in place of the value of $A_1 (\lambda)$ at the $\lambda_{max}$, an average of the value of $A_1 (\lambda)$ with respect to a specific wavelength range including $\lambda_{max}$. The specific wavelength range of the case is, for example, preferably 300 nm or more and equal to or less than a rising point of the absorbance spectrum (absorbance threshold), and more preferably from a wavelength $\lambda$ which is equal to or more than $\lambda_{max}$ to a wavelength $\lambda$ which provides 0.0001 (O. D. /$\mu$m) or more as a value of $\{log(I_0 (\lambda)/I(\lambda))\}/t$ (an absorbance per film thickness).

In a case in which evaluation is performed by using the average value with respect to a specific wavelength range as the value of $A_1 (\lambda)$, the value of $A_1 (\lambda)$ is preferably less than $1.5 \times 10^{-4}$ (O. D. /$\mu$m), more preferably $1.2 \times 10^{-4}$ (O. D. /$\mu$m) or less, and further preferably $1.0 \times 10^{-4}$ (O. D. /$\mu$m) or less.

Further, evaluation of the conversion efficiency obtained when a photovoltaic cell is formed may be performed in the invention by using, in place of the value of $A_1 (\lambda)$ at the $\lambda_{max}$, an integrated value of $A_1 (\lambda)$ with respect to a specific wavelength range including $\lambda_{max}$. The specific wavelength range for the case using the integrated value of $A_1 (\lambda)$ is similar to that described above.

In a case in which evaluation is performed by using the integrated value with respect to a specific wavelength range, the integrated value of $A_1 (\lambda)$ with respect to a specific wavelength range is preferably $7.0 \times 10^{-3}$ or less, more preferably $6.0 \times 10^{-3}$ or less, and further preferably $5.0 \times 10^{-3}$ or less.

It is also preferable in the invention to conduct the evaluation by using, in place of the value of $A_1 (\lambda)$ represented by Equation 1, a value of $A_2 (\lambda)$ represented by the following Equation 2. In general, the value of $A_1 (\lambda)$ and the value of $A_2 (\lambda)$ are theoretically equivalent, and the selection of the value of $A_1 (\lambda)$ or the value of $A_2 (\lambda)$ can be appropriately done according to a measuring apparatus which is available to conduct the evaluation.

$$\text{Equation 2:} \qquad A_2(\lambda) = a(\lambda)/t - a_{ref}(\lambda)/t_{ref}$$

In Equation 2, $a(\lambda)$ is an absorbance of a resin film, which is formed from the resin composition and has a thickness of t ($\mu$m), the absorbance being obtained as a result of incident light having a wavelength $\lambda$ (nm) having passed through the resin film in the thickness direction of the resin film; and $a(\lambda)$ is an absorbance of a reference resin film, which is formed from a reference resin composition obtained by excluding the fluorescent substance and the resin particles from the resin composition and has a thickness of $t_{ref}$ ($\mu$m), the absorbance being obtained as a result of the incident light having passed through the reference resin film in the thickness direction of the reference resin film.

The value of $A_2 (\lambda)$ at the wavelength $\lambda_{max}$ (nm) is preferably $3.0 \times 10^{-4}$ (O. D. /$\mu$m) or less, more preferably $2.5 \times 10^{-4}$ (O. D. /$\mu$m) or less, and further preferably $2.0 \times 10^{-4}$ (O. D. /$\mu$m) or less in the invention, in view of the conversion efficiency of a photovoltaic cell.

Further, as necessary, the value of $A_2 (\lambda)$ may be evaluated in the invention by using, in place of the value of $A_2 (\lambda)$ at the $\lambda_{max}$, an average of the value of $A_2 (\lambda)$ with respect to a specific wavelength range including $\lambda_{max}$. The specific wavelength range of the case is, for example, preferably equal to or more than $\lambda_{max}$ and equal to or less than a rising point of the absorbance spectrum (absorbance threshold), and more preferably equal to or more than $\lambda_{max}$ and a equal to or less than a wavelength $\lambda$ which provides 0.0001 (O. D. /$\mu$m) or more as a value of $a(\lambda)/t$.

Examples of a concrete method for configuring the wavelength-converting resin composition of the invention to have the value of $A_1 (\lambda)$ (or the value of $A_2 (\lambda)$ in a predetermined range include: a method which disperses a resultant obtained by encapsulating the fluorescent substance in the resin particles in a dispersion medium resin in which the resultant can be dispersed to configure the wavelength-converting resin composition; a method which disperses a polymer dispersant-coated fluorescent substance, which is obtained by subjecting the fluorescent substance to a dispersing treatment with a polymer dispersant, in a dispersion medium resin in which the resultant can be dispersed to configure the wavelength-converting resin composition; and a method which simply reduce a content of the fluorescent substance. In the invention, the method is preferably that using the resultant obtained by encapsulating the fluorescent substance in the resin particles or the polymer dispersant-coated fluorescent substance.

Details of these methods are described below.

(Fluorescent substance)

There is no particular limitation to the fluorescent substance used in the invention as long as it is a compound which can convert light that is outside a wavelength range which can be used by a usual photovoltaic cell to light that is within a wavelength range which can be used by a photovoltaic cell. Examples thereof include an inorganic fluorescent body, an organic fluorescent body, and a rare earth metal complex containing an organic ligand.

Examples of the inorganic body include: a fluorescent particle of $Y_2O_2S$: Eu, Mg, Ti; an oxyfluoride crystalline glass containing $Er^{3+}$ ion; and inorganic fluorescent substances such as: $SrAl_2O_4$: Eu, Dy, which is formed by adding rare earth elements europium (Eu) and dysprosium (Dy) to a compound formed of strontium oxide and aluminum oxide; $Sr_4Al_{14}O_{25}$: Eu, Dy; $CaAl_2O_4$:Eu,Dy; and ZnS:Cu.

Further, examples of the organic body include: organic dyes such as a cyanine dye, a pyridine dye, and a rhodamine dye; LUMOGEN F VIOLET 570, LUMOGEN F YELLOW083, LUMOGEN F ORANGE240, and LUMOGEN F RED300 manufactured by BASF; basic dye of RHODAMINE B manufactured by Taoka Chemical Co., Ltd.; and organic bodies such as SUMIPLAST YELLOW FL7G manufactured by Sumika Fine-Chem Co., Ltd. and MACROLEX FLUORESCENT RED G and MACROLEX FLUORESCENT YELLOW10GN manufactured by Bayer.

The fluorescent substance in the invention is preferably the rare earth metal complex containing an organic ligand, that is, an organic complex of rare earth metal in view of the wave conversion efficiency. Among thereof, it is preferably at least one of a europium complex or a samarium complex in view of the wave conversion efficiency. The ligand which forms the organic complex is not particularly limited and can be selected according to a metal to be used. Among thereof, it is preferably a ligand which can form a complex with at least one of europium or samarium.

Although the ligand is not limited in the present invention, it is preferably at least one selected from carboxylic acid, a nitrogen-containing organic compound, a nitrogen-containing aromatic heterocyclic compound, a β-diketone, and a phosphine oxide, which are neutral ligands. A β-diketone which is represented by a formula $R^1COCHR^2COR^3$ (wherein $R^1$ represents an aryl group, an alkyl group, a cycloalkyl group, a cycloalkylalkyl group, an aralkyl group, or a substituted body thereof; $R^2$ represents a hydrogen atom, an alkyl group, a cycloalkyl group, a cycloalkylalkyl group, an aralkyl group or an aryl group; and $R^3$ represents an aryl group, an alkyl group, a cycloalkyl group, a cycloalkylalkyl group, an aralkyl group or a substituted body thereof). may be contained as a ligand for the rare earth metal complex.

Specific examples of the β-diketone include acetylacetone, perfluoroacetylacetone, benzoyl-2-furanoylmethane, 1,3-bis(3-pyridyl)-1,3-propanedione, benzoyltrifluoroacetone, benzoylacetone, 5-chlorosulfonyl-2-tenoyltrifluoroacetone, di(4-bromo)benzoylmethane, dibenzoylmethane, d,d-dicamphorylmethane, 1,3-dicyano-1,3-propanedione, p-di(4,4,5,5,6,6,6-heptafluoro-1,3-hexanedinoyl)benzene, 4,4'-dimethoxydibenzoylmethane, 2,6-dimethyl-3,5-heptanedione, dinaphthoylmethane, dipivaloylmethane, di(perfluoro-2-propoxypropionyl)methane, 1,3-di(2-thienyl)-1,3-propanedione, 3-(trifluoroacetyl)-d-camphor, 6,6,6-trifluoro-2,2-dimethyl-3,5-hexanedione, 1,1,1,2,2,6,6,7,7,7-decafluoro-3,5-heptanedione, 6,6,7,7,8,8,8-heptafluoro-2,2-dimethyl-3,5-octanedione, 2-furyltrifluoroacetone, hexafluoroacetylacetone, 3-(heptafluorobutyryl)-d-camphor, 4,4,5,5,6,6,6-heptafluoro-1-(2-thienyl)-l,3-hexanedione, 4-methoxydibenzoylmethane, 4-methoxybenzoyl-2-furanoylmethane, 6-methyl-2,4-heptanedione, 2-naphthoyltrifluoroacetone, 2-(2-pyridyl)benzimidazole, 5,6-dihydroxy-10-phenanthroline, 1-phenyl-3-methyl-4-benzoyl-5-pyrazole, 1-phenyl-3-methyl-4-(4-butylbenzoyl)-5-pyrazole, 1-phenyl-3-methyl-4-isobutyryl-5-pyrazole, 1-phenyl-3-methyl-4-trifluoroacetyl-5-pyrazole, 3-(5-phenyl-1,3,4-oxadiazol-2-yl)-2,4-pentanedione, 3-phenyl-2,4-pentanedione, 3-[3',5'-bis(phenylmethoxy)phenyl]-1-(9-phenanthyl)-1-propane-1,3-dione, 5,5-dimethyl-1,1,1-trifluoro-2,4-hexanedione, 1-phenyl-3-(2-thienyl)-1,3-propanedione, 3-(t-butylhydroxymethylene)-d-camphor, 1,1,1-trifluoro-2,4-pentanedione, 1,1,1,2,2,3,3,7,7,8,8,9,9,9-tetradecafluoro-4,6-nonanedione, 2,2,6,6-tetramethyl-3,5-heptanedione, 4,4,4-trifluoro-1-(2-naphthyl)-1,3-butanedione, 1,1,1-trifluoro-5,5-dimethyl-2,4-hexanedione, 2,2,6,6-tetramethyl-3,5-heptanedione, 2,2,6,b-tetramethyl-3,5-octanedione, 2,2,6-trimethyl-3,5-heptanedione, 2,2,7-trimethyl-3,5-octanedione, 4,4,4-trifluoro-1-(thienyl)-1,3-butanedione (TTA), 1-(p-t-butylphenyl)-3-(N-methyl-3-pyrrole)-1,3-propanedione (BMPP), 1-(p-t-butylphenyl)-3-(p-methoxyphenyl)-1,3-propanedione (BMDBM), 1,3-diphenyl-1,3-propanedione, benzoylacetone, dibenzoylacetone, diisobutyroylmethane, dipivaloylmethane, 3-methylpentane-2,4-dione, 2,2-dimethylpentane-3,5-dione, 2-methyl-1,3-butanedione, 1,3-butanedione, 3-phenyl-2,4-pentanedione, 1,1,1-trifluoro-2,4-pentanedione, 1,1,1-trifluoro-5,5-dimethyl-2,4-hexanedione, 2,2,6,6-tetramethyl-3,5-heptanedione, 3-methyl-2,4-pentanedione, 2-acetylcyclopentanone, 2-acetylcyclohexanone, 1-heptafluoropropyl-3-t-butyl-1,3-propanedione, 1,3-diphenyl-2-methyl-1,3-propanedione, and 1-ethoxy-1,3-butanedion.

Examples of the nitrogen-containing organic compound, the nitrogen-containing aromatic heterocyclic compound and the phosphine oxide as the neutral ligand of the rare earth metal complex include 1,10-phenanthroline, 2,2'-bipyridyl, 2,2'-6,2''-terpyridyl, 4,7-diphenyl-1,10-phenanthroline, 2-(2-pyridyl)benzimidazole, triphenylphosphine oxide, tri-n-butylphosphine oxide, tri-n-octylphosphine oxide, and tri-n-butyl phosphate.

Among the rare earth metal complex having the ligand as described above, for example, Eu(TTA)$_3$phen, Eu(BMPP)$_3$phen, Eu(BMDBM)$_3$phen or the like can be preferably used in view of the wavelength conversion efficiency. With respect to a method for producing the Eu(TTA)$_3$phen and the like, for example, the method disclosed in J. Mater. Chem. (2003) 13, pp. 285-2879 by Masaya Mitsuishi, Shinji Kikuchi, Tokuji Miyashita, and Yutaka Amano may be referred to.

In the invention, a photovoltaic cell module having a high power generation efficiency can be configured by specifically using a europium complex as the fluorescent substance. A europium complex converts light in the ultraviolet region to light in the red wavelength region with high wavelength conversion efficiency, and this converted light contributes to the power generation in a photovoltaic cell.

The content of the fluorescent substance in the wavelength-converting resin composition can be appropriately selected in accordance with the fluorescent substance and the resin particles to be used. For example, it may be in a range of from 0.0001 mass% to 1 mass%, preferably from 0.0001 mass% to 0.1 mass%, and more preferably from 0.0001 mass% to 0.02 mass% with respect to a total amount of non-volatile components (total solid content) of the wavelength-converting resin composition.

The emission efficiency is further improved by setting it to 0.0001 mass% or more. Further, decrease in the emission efficiency due to concentration quenching or scattering can be suppressed and decrease in the power generation due to scattering of incident light can be suppressed by setting it to 1 mass% or less.

Further, it is preferable in the invention that the fluorescent substance is at least one selected from $Eu(TTA)_3phen$, $Eu(TTA)_3Bpy$, $Eu(TTA)_3(TPPO)_2$, $Eu(BMPP)_3phen$, or $Eu(BMDBM)_3phen$ and the content thereof is in a range of from 0.0001 mass% to 1 mass% with respect to the total solid content of the wavelength-converting resin composition.

The fluorescent substance is preferably used in the invention in a form of a wavelength-converting fluorescent material in which the fluorescent substance is encapsulated in the resin particles described below or a wavelength-converting fluorescent material in which the fluorescent substance is covered by a polymer dispersant. Scattering of light which is in a wavelength region contributing less to photovoltaic power generation can be more efficiently suppressed thereby.

This more efficient light scattering suppression can be thought as being caused since, for example, the fluorescent substance, which has a larger refractive index than a dispersion medium resin, is encapsulated or covered by a polymer compound (the resin particles or the polymer dispersant), which exhibits an refractive index which is similar to that of the dispersion medium resin.

(Resin particles)

The wavelength-converting resin composition of the invention contains at least one kind of resin particles. The resin particles are preferably capable of encapsulating the fluorescent substance.

A primary particle diameter of the resin particles is preferably from 1 $\mu$m to 1,000 $\mu$m, and more preferably from 10 $\mu$m to 500 $\mu$m, in view of improving light utilization efficiency.

The primary particle diameter of the wavelength-converting fluorescent material can be performed by using a laser diffraction particle size analyzer (for example, LS 13320 manufactured by Beckman Coulter Inc.).

The monomer for configuring the resin particles is not particularly limited and may be an addition-polymerizable monomer or a condensation-polymerizable monomer. In the invention, it is preferably an addition-polymerizable vinyl compound in view of stability of the fluorescent substance (preferably a rare earth metal complex having an organic ligand) and the power generation efficiency.

- Vinyl compound -

The vinyl compound is not particularly limited in the invention as long as it is a compound having at least one ethylenically-unsaturated bond, and an acrylic monomer, a methacrylic monomer, an acrylic oligomer, a methacrylic oligomer or the like, which can form a vinyl resin, particularly an acrylic resin or a methacrylic resin, when subjected to a polymerization reaction can be used without particular limitation. An acrylic monomer, a methacrylic monomer, and the like can be preferably used in the invention.

Examples of the acrylic monomer and the methacrylic monomer include acrylic acid, methacrylic acid, and alkyl esters thereof. Other vinyl monomers which are copolymerizable with these monomers may also be used in combination. The monomers can be used singly or in combination of two or more kinds.

Examples of the acrylic acid alkyl ester and the methacrylic acid alkyl ester include acrylic acid unsubstituted alkyl esters or methacrylic acid unsubstituted alkyl esters such as methyl acrylate, methyl methacrylate, ethyl acrylate, ethyl methacrylate, butyl acrylate, butyl methacrylate, 2-ethylhexyl acrylate, and 2-ethylhexyl methacrylate; dicyclopentenyl(meth)acrylate; tetrahydrofurfuryl(meth)acrylate; a compound obtainable by allowing a polyhydric alcohol to react with an $\alpha,\beta$-unsaturated carboxylic acid (for example, polyethylene glycol di(meth)acrylate (having a number of ethylene groups of from 2 to 14), trimethylolpropane di(meth)acrylate, trimethylolpropane tri(meth)acrylate, trimethylolpropane ethoxytri(meth)acrylate, trimethylolpropane propoxytri(meth)acrylate, tetramethylolmethane tri(meth)acrylate, tetramethylolmethane tetra(meth)acrylate, polypropylene glycol di(meth)acrylate (having a number of propylene groups of from 2 to 14), dipentaerythritol penta(meth)acrylate, dipentaerythritol hexa(meth)acrylate, bisphenol A polyoxyethylene di (meth)acrylate, bisphenol A dioxyethylene di(meth)acrylate, bisphenol A trioxyethylene di(meth)acrylate, or bisphenol A decaoxyethylene di(meth)acrylate); a compound obtainable by adding an $\alpha,\beta$-unsaturated carboxylic acid to a glycidyl group-containing compound (for example, trimethylolpropane triglycidyl ether triacrylate, or bisphenol A diglycidyl ether diacrylate); an esterification product of a polyvalent carboxylic acid (for example, phthalic anhydride) and a substance having a hydroxyl group and an ethylenically unsaturated group (for example, β-hydroxyethyl (meth)acrylate); urethane (meth)acrylate (for example, a reaction product between tolylene diisocyanate and a 2-hydroxyethyl(meth)acrylic acid ester, or a reaction product between trimethylhexamethylene diisocyanate, cyclohexanedimethanol, and a 2-hydroxyethyl (meth)acrylic acid ester); and an acrylic acid substituted alkyl ester or a methacrylic acid substituted alkyl ester in which its alkyl group has a hydroxyl group, an epoxy group, a halogen group or the like as a substituent.

Examples of other vinyl monomers that are copolymerizable with acrylic acid, methacrylic acid, an acrylic acid alkyl ester or a methacrylic acid alkyl ester include acrylamide, acrylonitrile, diacetone acrylamide, styrene, and vinyltoluene. These vinyl monomers can be used singly or in combination of two or more kinds.

The vinyl compound is preferably appropriately selected in the invention so that the refractive index of the resin particles formed thereby become a desired value, and is preferably at least one selected from an acrylic acid alkyl ester or a methacrylic acid alkyl ester.

(Radical Polymerization Initiator)

A radical polymerization initiator is preferably used for polymerizing the vinyl compound in the invention. The radical polymerization initiator is not particularly limited and radical polymerization initiators which are usually used can be used. Preferable examples include peroxide. Specifically, an organic peroxide which generates a free radical by heat and an azo radical initiator are preferable.

Examples of the organic peroxide include isobutyl peroxide, . α, α'-bis(neodecanoylperoxy)diisopropylbenzene, cumyl peroxyneodecanoate, di-n-propyl peroxydicarbonate, di-s-butyl peroxydicarbonate, 1,1,3,3-tetramethylbutyl neodecanoate, bis(4-t-butylcyclohexyl) peroxyd icarbonate, 1-cyclohexyl-1-methylethyl peroxyneodecanoate, di-2-ethoxyethyl peroxydicarbonate, di(ethylhexylperoxy)dicarbonate, t-hexyl neodecanoate, dimethoxybutyl peroxydicarbonate, di (3-methyl-3-methoxybutylperoxy)dicarbonate, t-butyl peroxyneodecanoate, t-hexyl peroxypivalate, 3,5,5-trimethylhexanoyl peroxide, octanoyl peroxide, lauroyl peroxide, stearoyl peroxide, 1,1,3,3-tetramethylbutyl peroxy-2-ethylhexanoate, succinic peroxide, 2,5-dimethyl-2,5-di(2-ethylhexanoyl)hexane, 1-cyclohexyl-1-methylethyl peroxy-2-ethylhexanoate, t-hexyl peroxy-2-ethylhexanoate, 4-methylbenzoyl peroxide, t-butylperoxy-2-ethylhexanoate, m-toluonoylbenzoyl peroxide, benzoyl peroxide, t-butyl peroxyisobutyrate, 1,1-bis(t-butylperoxy)-2-methylcyclohexane, 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-bis(t-butylperoxy)cyclohexanone, 2,2-bis(4,4-dibutylperoxycyclohexyl)propane, 1,1-bis(t-butylperoxy)cyclododecane, t-hexyl peroxyisopropyl monocarbonate, t-butyl peroxymaleic acid, t-butylperoxy-3,5,5-trimetlₗylhexanoate, t-butyl peroxylaurate, 2,5-dimethyl-2,5-di(m-toluoylperoxy)hexane, t-butyl peroxyisopropyl monocarbonate, t-butylperoxy-2-ethylhexyl monocarbonate, t-hexyl peroxybenzoate, 2,5-dimethyl-2,5-di(benzoylperoxy)hexane, t-butyl peroxyacetate, 2,2-bis(t-butylperoxy)butane, t-butyl peroxybenzoate, n-butyl 4,4-bis(t-butylperoxy)valerate, di-t-butyl peroxyisophthalate, α, α'-bis(t-butylperoxy)diisopropylbenzene, dicumyl peroxide, 2,5-dimethyl-2,5-di(t-butylperoxy)hexane, t-butyl cumyl peroxide, di-t-butylperoxy-p-menthane hydroperoxide, 2,5-dimethyl-2,5-di(t-butylperoxy)hexyne, diisopropylbenzene hydroperoxide, t-butyltrimethylsilyl peroxide, 1,1,3,3-tetramethylbutyl hydroperoxide, cumene hydroperoxide, t-hexyl hydroperoxide, t-butyl hydroperoxide, and 2,3-dimethyl-2,3-diphenylbutane.

Examples of the azo radical initiator include azobisisobutyronitrile (AIBN" V-60 (trade name, manufactured by Wako Pure Chemicals Industries, Ltd.), 2,2-azobis(2-methylisobutyronitrile) (V-59 (trade name, manufactured by Wako Pure Chemicals Industries, Ltd.)), 2,2-azobis(2,4-dimethylvaleronitrile) (V-65 (trade name, manufactured by Wako Pure Chemicals Industries, Ltd.)), dimethyl-2,2-azobis(isobutyrate) (V-601 (trade name, manufactured by Wako Pure Chemicals Industries, Ltd.)), and 2,2-azobis(4-methoxy-2,4-dimethylvaleronitrile) (V-70 (trade name, manufactured by Wako Pure Chemicals Industries, Ltd.)).

An amount of the radical polymerization initiator to be used may be appropriately selected according to the kind of the vinyl compound, the refractive index of the resin particles formed thereby, and/or the like, and is a usually-employed amount. Specifically, for example, it may be used in an amount of 0.01 to 2 % by mass, and is preferably used in an amount of 0.1 to 1 % by mass, with respect to the vinyl compound.

(Wavelength-converting fluorescent material)

The wavelength-converting material in the invention is the resin particles encapsulating the fluorescent substance or the fluorescent substance covered with the polymer dispersant.

These may be prepared by, for example, preparing a mixture of the fluorescent substance and monomer compounds which form the resin particles, and subject it to polymerization. Specifically, for example, the wavelength-converting fluorescent material may be formed as resin particles in which a fluorescent substance is encapsulated by preparing a mixture of the fluorescent substance and a vinyl compound, and subject it to polymerization using a radical polymerization initiator.

Further, for example, the wavelength-converting fluorescent material in which the fluorescent substance is covered with a water-insoluble polymer dispersant may be formed by dispersing the fluorescent substance into an aqueous medium by using the polymer dispersant.

Specifically, for example, the wavelength-converting fluorescent material may be formed as a fluorescent substance which is covered with a water-insoluble vinyl polymer dispersant containing a hydrophilic structure unit and a hydrophobic structure unit by dispersing the vinyl polymer dispersant and the fluorescent substance in an aqueous medium. There is not particular limitation to the dispersing method and conventionally-known dispersing method may be employed.

An explanation of a production method of the wavelength-converting fluorescent material in which the wavelength-converting fluorescent material is encapsulated in the resin particles is given hereinafter as one example of a production method of the wavelength-converting fluorescent material of the invention.

The wavelength-converting fluorescent material is obtained by mixing the fluorescent substance and the vinyl compound, and optionally a radical polymerization initiator such as a peroxide and/or the like as necessary, and dissolving or dispersing the fluorescent substance in the vinyl compound. The method of mixing is not particularly limited, and for example, mixing may be carried out by stirring.

A content of the fluorescent substance may be preferably in the range of from 0.001 to 10 % by mass with respect to the vinyl compound, and more preferably in the range of from 0.01 to 1.0 % by mass. When the fluorescent substance is contained within this range, the fluorescent substance is dissolved in the vinyl compound to configure a wavelength-converting fluorescent material having further excellent light transmission property.

In the invention, the vinyl compound is preferably appropriately selected such that the wavelength-converting fluorescent materials has good dispersibility in a transparent dispersion medium resin when the wavelength-converting fluorescent material after polymerization is dispersed into the transparent dispersion medium resin,.

Specifically, the state with good dispersibility refers to a state in which scattering that causes light loss is sufficiently suppressed in a wavelength conversion layer formed from the wavelength-converting resin composition of the invention. Such a state with good dispersibility (a state in which light scattering is suppressed) may be achieved by, for example, the method described below.

A resin formulation of the wavelength-converting fluorescent material is selected to be one exhibiting good dispersibility in relation to a formulation of a dispersion medium resin so as not to cause phase separation therefrom. This may be achieved by, for example, selecting each resin formulation by referring haze as an index.

Further, in order to obtain a condition causing little light scattering, the vinyl compound and the fluorescent substance may be selected such that the fluorescent substance does not precipitate therefrom in the wavelength-converting fluorescent material at before and after polymerization. For example, with respect to a rare earth metal complex among the fluorescent substance, precipitation of the fluorescent substance in the vinyl compound may be obviated by varying a ligand, and thus a favorable mixture state (preferably a dissolved state) can be obtained.

Further, light scattering may be reduced by reducing a concentration of a material which causes light scattering. For example, in a case in which precipitation of the fluorescent substance is a cause of light scattering, it may be addressed by reducing a concentration of he fluorescent substance in the wavelength-converting fluorescent material. In a case in which the wavelength-converting fluorescent material in the dispersion medium resin is a cause of light scattering, it may be addressed by reducing the concentration thereof.

The content of the wavelength-converting fluorescent material in the wavelength-converting resin composition of the invention is preferably from 0.0001 to 1 % by mass, and more preferably from 0.0005 to 0.01 % by mass, with respect to the total amount of non-volatile components of the wavelength-converting resin composition, in terms of the mass concentration of an organic complex of a rare earth metal (preferably a europium complex).

The emission efficiency is further improved by setting it to 0.0001 % by mass or more. Further, decrease in the emission efficiency due to concentration quenching can be suppressed and decrease in the power generation efficiency due to scattering of incident light can be suppressed by setting it to 1 mass% or less.

(Dispersion medium resin)

There is no particular limitation to a dispersion medium resin which forms the wavelength-converting resin composition of the invention as long as it is a transparent resin in which the wavelength-converting fluorescent material can be dispersed, and preferable examples thereof include a photo-curable resin, a thermosetting resin, and a thermoplastic resin.

Among thereof, those containing ethylene-vinyl acetate copolymers (also referred to as "EVA") unparted with thermosetting property, which are usually used as resins for a sealant for a photovoltaic cell, are preferable.

Note that the transparent sealant resin which also served as a dispersion medium is not limited to EVA, and it may further include a thermoplastic resin, a thermosetting resin, and a photo-curable resin which are other than EVA.

In a case in which the transparent dispersion medium resin is configured with including a photo-curable resin, there is no particular limitation to a resin configuration of the photo-curable resin or a photo-curing method. For example, in a photo-curing method based on a photo-radical polymerization initiator, the wavelength-converting resin composition may be configured with including, in addition to the wavelength-converting fluorescent material, (A) a binder resin, (B) a cross-linkable monomer, (C) a photo-polymerization initiator that produces a free radical under the action of light or heat, and/or the like.

Examples of the (A) binder resin include homopolymers having acrylic acid, methacrylic acid or an alkyl ester thereof as a constituent monomer, and copolymers formed by copolymerizing these monomers and other vinyl monomers that are copolymerizable with the foregoing monomers as constituent monomers. These copolymers can be used singly, or two or more kinds can also be used in combination.

Examples of the acrylic acid alkyl ester and the methacrylic acid alkyl ester include: an acrylic acid unsubstituted alkyl ester or a methacrylic acid unsubstituted alkyl ester such as methyl acrylate, methyl methacrylate, ethyl acrylate, ethyl methacrylate, butyl acrylate, butyl methacrylate, 2-ethylhexyl acrylate, or 2-ethylhexyl methacrylate; and those in which alkyl groups are substituted with a hydroxyl group, an epoxy group, a halogen group or the like, namely an acrylic acid substituted alkyl ester or amethacrylic acid substituted alkyl ester.

Further, examples of the other vinyl monomer that are copolymerizable with acrylic acid, methacrylic acid, an acrylic acid alkyl ester or a methacrylic acid alkyl ester include acrylamide, acrylonitrile, diacetoneacrylamide, styrene, and vinyltoluene. These vinyl monomers may be used singly or in combination of two or more kinds. Further, the weight-average molecular weight of the (A) binder resin which configures the dispersion medium resin is preferably in a range of from 10,000 to 300,000 in view of film-forming property and film strength.

Examples of the (B) cross-linkable monomer include a compound obtained by reacting a polyhydric alcohol with an $\alpha,\beta$-unsaturated carboxylic acid (such as polyethylene glycol di(meth)acrylate (having a number of ethyleneoxy group of 2 to 14), trimethylolpropane di(meth)acrylate, trimethylolpropane tri(meth)acrylate, trimethylolpropane ethoxytri (meth)acrylate, trimethylolpropane propoxytri(meth)acrylate, tetramethylolmethane tri(meth)acrylate, tetramethylolmethane tetra(meth)acrylate, polypropylene glycol di(meth)acrylate (having a number of propyleneoxy groups of 2 to 14), dipentaerythritol penta(meth)acrylate, dipentaerythritol hexa(meth)acrylate, bisphenol A polyoxyethylene di(meth) acrylate, bisphenol A dioxyethylene di(meth)acrylate, bisphenol A trioxyethylene di(meth)acrylate, or bisphenol A decaoxyethylene di(meth)acrylate); a compound obtained by adding an $\alpha,\beta$-unsaturated carboxylic acid to a glycidyl group-containing compound (such as trimethylolpropane triglycidyl ether triacrylate or bisphenol A diglycidyl ether diacrylate); a esterification product of a polyvalent carboxylic acid (for example, phthalic anhydride) and a substance having a hydroxyl group and an ethylenically unsaturated group (such as ($\beta$-hydroxyethyl (meth)acrylate); and a urethane (meth) acrylate (such as a reaction product between tolylene diisocyanate and 2-hydroxyethyl(meth)acrylic acid ester, or a reaction product between trimethylhexamethylene diisocyanate, cyclohexanedimethanol and 2-hydroxyethyl(meth)acrylic acid ester).

Particularly preferable examples of the (B) cross-linkable monomer include trimethylolpropane tri(meth)acrylate, dipentaerythritol tetra(meth)acrylate, dipentaerythritol hexa(meth)acrylate, and bisphenol A polyoxyethylene dimethacrylate, from the viewpoint of easiness in controllability of the cross-linking density or the reactivity. The compounds described above may be used singly or in combination of two or more kinds.

Particularly, in a casein which the refractive index of the wavelength-converting resin composition is set to be high, it is advantageous that at least one of the (A) binder resin or the (B) cross-linkable monomer contains a bromine atom or a sulfur atom. Examples of the bromine-containing monomer include NEW FRONTIER BR-31, NEW FRONTIER BR-30, and NEW FRONTIER BR-42M manufactured by Daiichi Kogyo Co., Ltd. Examples of the sulfur-containing monomer composition include IU-L2000, IU-L3000, and IU-MS 1010 manufactured by Mitsubishi Gas Chemical Co., Inc. The bromine atom-containing monomer and the sulfur atom-containing monomer (and polymers containing thereof) which can be used in the invention are not limited to those listed herein.

A photo-polymerization initiator which produces a free radical under the action of ultraviolet radiation or visible light is preferable as the (C) photo-polymerization initiator, and examples thereof include: benzoin ethers such as benzoin methyl ether, benzoin ethyl ether, benzoin propyl ether, benzoin isobutyl ether, and benzoin phenyl ether; benzophenones such as benzophenone, N,N'-tetramethyl-4,4'-diaminobenzophenone (Michler's ketone), and N,N'-tetraethyl-4,4'-diaminobenzophenone; benzyl ketals such as benzyl dimethyl ketal (IRGACURE 651 manufactured by BASF Japan) and benzyl diethyl ketal; acetophenones such as 2,2-dimethoxy-2-phenylacetophenone, p-tert-butyldichloroacetophenone, and p-dimethylaminoacetophenone; xanthones such as 2,4-dimethylthioxanthone and 2,4-diisopropylthioxanthone; hydroxycyclohexyl phenyl ketone (IRGACURE 184 manufactured by BASF Japan); 1-(4-isopropylphenyl)-2-hydroxy-2-methylpropan-1-one (DAROCURE 1116 manufactured by BASF Japan); and 2-hydroxy-2-methyl-1-phenylpropan-1-one (DAROCURE 1173 manufactured by BASF Japan). These are used singly or in combination of two or more kinds.

Further, examples of a photo-polymerization initiator which can be used as the (C) photo-polymerization initiator include combinations of a 2,4,5-triallylimidazole dimer with 2-mercaptobenzoxazole, leuco crystal violet, tris(4-diethylamino-2-methylphenyl)methane or the like. Further, an additive which itself does not have photo-initiation property but configurates a sensitizer system having more satisfactory photo-initiation performance in total when used in combination with the substances described above may be used, and examples thereof include a tertiary amine such as triethanolamine in conjunction with benzophenone.

Further, in place of the photo-curable resin, a thermo-setting resin may be used as the dispersion medium resin. One having the same configuration as that of the photo-curable resin except that the (C) photo-polymerization initiator therein is changed to a thermal polymerization initiator may be used as the thermo-setting resin.

An organic peroxide which produces a free radical under the action of heat is preferable as the (C) thermal polymerization initiator. Examples thereof include isobutyl peroxide, $\alpha,\alpha'$-bis(neodecanoylperoxy)diisopropylbenzene, cumyl peroxyneodecanoate, di-n-propyl peroxydicarbonate, di-s-butyl peroxydicarbonate, 1,1,3,3-tetramethylbutyl neodecanoate, bis(4-t-butylcyclohexyl) peroxydicarbonate, 1-cyclohexyl-1-methylethyl peroxyneodecanoate, di-2-ethoxyethyl peroxydicarbonate, di(ethylhexylperoxy)dicarbonate, t-hexyl neodecanoate, dimethoxybutyl peroxydicarbonate, di(3-methyl-3-methoxybutylperoxy)dicarbonate, t-butyl peroxyneodecanoate, t-hexyl peroxypivalate, 3,5,5-trimethylhexanoyl peroxide, octanoyl peroxide, lauroyl peroxide, stearoyl peroxide, 1,1,3,3-tetramethylbutyl peroxy-2-ethylhexanoate, succinic peroxide, 2,5-dimethyl-2,5-di(2-ethylhexanoyl)hexane, 1-cyclohexyl-1-methylethyl peroxy-2-ethylhexanoate, t-hexyl peroxy-2-ethylhexanoate, 4-methylbenzoyl peroxide, t-butyl peroxy-2-ethylhexanoate, m-toluonoylbenzoyl peroxide, benzoyl peroxide, t-butyl peroxyisobutyrate, 1,1-bis(t-butylperoxy)-2-methylcyclohexane, 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-bis(t-butylperoxy)cyclohexanone, 2,2-bis(4,4-dibutylperoxycyclohexyl)propane, 1,1-bis(t-butylperoxy)cyclododecane, t-hexyl peroxyisopropyl monocarbonate, t-butylperoxymaleic acid, t-butyl peroxy-3,5,5-trimethylhexanoate, t-butyl peroxylaurate, 2,5-dimethyl-2,5-di(m-toluoylperoxy)hexane, t-butyl peroxyisopropyl monocarbonate, t-butyl peroxy-2-ethylhexyl monocarbonate, t-hexyl peroxybenzoate, 2,5-dimethyl-2,5-di(benzoylperoxy)hexane, t-butyl peroxyacetate, 2,2-bis(t-butylperoxy)butane, t-butyl peroxybenzoate, n-butyl 4,4-bis(t-butylperoxy)valerate, di-t-butyl peroxyisophthalate, $\alpha,\alpha'$-bis(t-butylperoxy)diisopropylbenzene, dicumyl peroxide, 2,5-dimethyl-2,S-di(t-butylperoxy)hexane, t-butyl cumyl peroxide, di-t-butylperoxy-p-menthane hydroperoxide, 2,5-dimethyl-2,5-di(t-butylperoxy)hexyne, diisopropylbenzene hydroperoxide, t-butyltrimethylsilyl peroxide, 1,1,3,3-tetramethylbutyl hydroperoxide, cumene hydroperoxide, t-hexyl hydroperoxide, t-butyl hydroperoxide, and 2,3-dimethyl-2,3-diphenylbutane.

A thermoplastic resin which is fluidized when heated or pressurized may be used as a transparent dispersion medium resin of the wavelength-converting resin composition of the invention. Examples of the thermoplastic resin include: a natural rubber; (di)enes such as polyethylene, polypropylene, polyvinyl acetate, polyisoprene, poly-1,2-butadiene, polyisobutene, polybutene, poly-2-heptyl-1,3-butadiene, poly-2-t-butyl-1,3-butadiene, and poly-1,3-butadiene; polyethers such as polyoxyethylene, polyoxypropylene, polyvinyl ethyl ether, polyvinyl hexyl ether, and polyvinyl butyl ether; polyesters such as polyvinyl acetate and polyvinyl propionate; polyurethane; ethyl cellulose; polyvinyl chloride; polyacrylonitrile; polymethacrylonitrile; polysulfone; phenoxy resin; and poly(meth)acrylic acid esters such as polyethyl acrylate, polybutyl acrylate, poly-2-ethylhexyl acrylate, poly-t-butyl acrylate, poly-3-ethoxypropyl acrylate, polyoxycarbonyl tetramethaciylate, polymethyl acrylate, polyisopropyl methacrylate, polydodecyl methacrylate, polytetradecyl methacrylate, poly-n-propyl methacrylate, poly-3,3,5-trimethylcyclohexyl methacrylate, polyethyl methacrylate, poly-2-nitro-2-methylpropyl methacrylate, poly-1,1-diethylpropyl methacrylate, and polymethyl methacrylate. These thermoplastic resins may be one that is obtained by copolymerizing two or more kinds of monomers as necessary. Two or more kinds of these thermoplastic resins may be used in a blend thereof.

Further, the thermoplastic resin may be a copolymer resin containing a structural unit derived from a monomer such as epoxy acrylate, urethane acrylate, polyether acrylate, or polyester acrylate. It is particularly preferably a copolymer resin containing a structural unit derived from urethane acrylate, epoxy acrylate, or polyether acrylate in view of adhesiveness.

Examples of epoxy acrylate include (meth)acrylic acid adducts such as 1,6-hexanediol diglycidyl ether, neopentyl glycol diglycidyl ether, allyl alcohol diglycidyl ether, resorcinol diglycidyl ether, adipic acid diglycidyl ester, phthalic acid diglycidyl ester, polyethylene glycol diglycidyl ether, trimethylolpropane triglycidyl ether, glycerin triglycidyl ether, pentaerythritol tetraglycidyl ether, and sorbitol tetraglycidyl ether.

Polymers having a hydroxyl group in their molecule, such as epoxy acrylate, are effective for enhancing adhesiveness. These copolymer resins can be used in combination of two or more kinds as necessary. The softening temperature of these resins is preferably 150°C or lower, and more preferably 100°C or lower, in view of a handling property. Considering that the environment temperature at which a photovoltaic cell units is used is usually 80°C or lower and an adaptability to processing, the softening temperature of the resins is particularly preferably in a range of from 80°C to 120°C.

The configuration of the wavelength-converting resin composition other than the thermoplastic resin is not particularly limited as long as the wavelength-converting fluorescent material of the invention is incorporated therein in a case in which the thermoplastic resin is used as a transparent dispersion medium resin, and components that are usually used, such as a plasticizer, a flame retardant, and a stabilizer, may be further incorporated therein.

A resin used for the transparent dispersion medium resin of the wavelength-converting resin composition of the invention is not particularly limited to be photo-curable, thermosetting, or thermoplastic as described above. Particularly preferable example of the resin include a composition obtained by mixing an ethylene-vinyl acetate copolymer (EVA), that is widely used as a conventional transparent dispersion medium resin for photovoltaic cells, with a thermoradical polymerization initiator, and optionally a cross-linking aid, an adhesive aid, an ultraviolet absorber, a stabilizer and the like.

The wavelength-converting resin composition of the invention has excellent moisture resistance due to the use of the wavelength-converting fluorescent material. Further, light can be efficiently introduced into a photovoltaic cell with suppressing scattering of light since the wavelength-converting fluorescent material has good dispersibility in the transparent dispersion medium resin.

The description that "the wavelength-converting fluorescent material has dispersibility in the transparent dispersion medium resin" herein means a state in which particles or turbidity cannot be recognized by visual inspection when the wavelength-converting fluorescent material is dispersed and mixed in the transparent dispersion medium resin, and more specifically, it means a state as described below.

First, the wavelength-converting fluorescent material is made to react so as to polymerize a vinyl compound containing the fluorescent substance. The conditions for this reaction are appropriately determined depending on the vinyl compound used.

The wavelength-converting fluorescent material is mixed with the transparent dispersion medium resin at a predetermined concentration to obtain the wavelength-converting resin composition, and the transparent dispersion medium resin is cured. The conditions for this curing can be also appropriately selected depending on the transparent dispersion medium resin used.

The turbidity of the cured wavelength-converting resin composition is measured using a haze meter (NDH-2000, manufactured by Nippon Denshoku Industries Co., Ltd.), and in a case in which the turbidity is 5% or less, it is understood that "the wavelength-converting fluorescent material has dispersibility in the transparent dispersion medium resin".

The most important point of the invention resides in the finding that the performance of a wavelength-converting resin composition in a crystalline silicone photovoltaic cell module is largely affected by not only the "turbidity" in the visible light region measurable by using a haze meter as described above, but also light loss due to absorption and scattering of light in a wavelength region that contributes less to photovoltaic power generation such as a maximum absorption wavelength in an absorbance spectrum of a fluorescent substance, and further resides in the finding of its measuring method. Details of the measuring method are described below.

(Preparation of Measurement sample)

Description is provided regarding a case in which EVA, which is widely used in a photovoltaic cell module as a dispersion medium resin, is used as one example of the wavelength-converting resin composition according to the invention, but the invention is not limited thereto.

100 parts by mass of an EVA resin (for example, NM30PW, that is an EVA resin manufactured by Tosoh Corporation), 2 parts by mass of TAIC (triallyl isocyanurate manufactured by Nippon Kasei Chemical Co., Ltd.), 1.3 parts by mass of LUPEROX 101 (2,5-dimethyl-2,5-(t-butylperoxy)hexane manufactured by Arkema Yoshitomi, Ltd.), 0.5 parts by mass of a silane coupling agent SZ 6030 (methacryloxypropyl trimethoxysilane manufactured by Dow Corning Toray Co., Ltd.), and a predetermined amount of the wavelength-converting resin material (for example, 2 parts by mass with respect to the total amount of non-volatile components of the wavelength-converting resin composition) are mixed and are kneaded in a roll mixer regulated to be at 90°C.

The thus-obtained kneaded product is made into a sheet-shaped resin composition having a thickness of 200 to 1,000 $\mu$m by using a hot press regulated to be at 90°C. This sheet-shaped resin composition is cut to have an appropriate size, put between a slide glass facing at one side thereof and a PET film facing at the other side thereof, and laminated by using a vacuum pressure laminator to provide a measurement sample. The condition of the laminator is set such that the temperature of a hot plate is 150°C, the pressure is 100 kPa, the time of vacuuming is 10 minutes, and the pressuring time is 15 minutes.

On the other hand, one that is obtained in the similar manner as described above except that the wavelength-converting fluorescent material is not mixed thereto is made as a reference sample.

(Confirmation of Measurement wavelength range)

The measurement wavelength range may be defined by an absorbance spectrum in the invention. The absorbance spectrum may be measured in accordance with a usual method by using a spectrophotometer (such as U-3300 manufactured by Hitachi High-Technologies Corporation or V-570 manufactured by JASCO Corporation). Cares should be herein taken to the fact that there are absorptions by a glass or PET which serves as a substrate in addition to the primary absorption which depends on the fluorescent substance in a case in which the measurement sample is one that made by the above-described measurement sample preparation method.

Further, there are cases in which peak wavelengths of an excitation spectrum and an absorbance spectrum of the fluorescent are different from each other as an essential characteristics of the fluorescent substance. The peak wavelength of an absorbance spectrum (maximum absorption wavelength) is employed in the invention.

In a case in which the measurement is performed in a wavelength including a peak wavelength of an absorbance spectrum (maximum absorption wavelength) in the invention, the range of the measurement may be, for example, equal to or more than the maximum absorption wavelength and equal to or less than a wavelength of a rising point of the absorbance spectrum (absorbance threshold). The wavelength which corresponds to the rising point of the absorbance spectrum is set to a wavelength which provides 0.0001 (O. D. /$\mu$m) or more of an absorbance.

(Measurement of Light loss in Measurement wavelength range)

There are cases in which a measurement of light loss in a measurement wavelength range is performed by irradiating a sample with monochromatic light and using a commercial spectrophotometer which can automatically carry out a calculation (such as U-3300 manufactured by Hitachi High-Technologies Corporation or V-570 manufactured by JASCO Corporation) or by irradiating a sample with all-wavelengths light and manually carry out a calculation (such as using a solar simulator WXS-1555-10, AM 1.5G manufactured by Wacom Electric Co., Ltd. or the like as a light source and measuring a spectral radiation intensity by using a solar simulator grating spectroradiometer LS-100 manufactured by Eko Instruments Co., Ltd.). The former is advantageous in that enables convenient measurement and evaluation, and the latter is advantageous in that it simultaneously enables a measurement of emission intensity.

The invention requires that the value of $A_1 (\lambda)$ at the maximum absorption wavelength measured by the latter is $3.0 \times 10^{-4}$ (O. D. /$\mu$m) or less, but as necessary, evaluation may be performed based on the value of $A_2 (\lambda)$ at the maximum absorption wavelength that is measured by the former.

<Method for Producing Wavelength-converting resin composition>

Examples of a method for producing the wavelength-converting resin composition of the invention includes a method including: obtaining a wavelength-converting fluorescent material by obtaining a mixture containing a fluorescent substance and a vinyl compound (preferably at least one of an acryl monomer or a methacryl monomer) and then polymerizing a vinyl monomer(s) in the mixture; and obtaining the wavelength-converting resin composition by mixing the wavelength-converting fluorescent material with a transparent dispersion medium resin.

(Step of Obtaining Wavelength-converting fluorescent material)

The mixture containing the fluorescent substance and the vinyl compound can be obtained by mixing, in addition to the fluorescent substance and the vinyl compound, a radical polymerization initiator such as peroxide, a chain transfer agent and/or the like. There are no particular limitations on the method of mixing, and the mixing may be carried out by, for example, ultrasonic mixing or stirring the system with a mix rotor, a magnetic stirrer, or a stirring blade.

The wavelength-converting fluorescent material can be obtained by polymerizing the vinyl compound in the obtained mixture. Conditions for the polymerization may be appropriately selected in accordance with the vinyl compound and the radical polymerization initiator used and may be appropriately adjusted by referring usual polymerization conditions.

The state of the polymer (wavelength-converting fluorescent material) thus produced can be selected in accordance with the glass transition temperature thereof. In a case of one having a high glass transition temperature such as methyl methacrylate, the polymer can be obtained in a particulate form by suspending, in water which has been maintained at a predetermined temperature and to which a surfactant is added, a liquid prepared by mixing the fluorescent substance and the radical polymerization initiator (suspension polymerization). It is also possible to obtain finer particles by suspending the system more finely by appropriately change the kind of the surfactant (emulsion polymerization).

In a case of one having a glass transition temperature which is lower than room temperature, such as butyl acrylate, the polymer can be obtained with a high viscosity by directly subjecting a liquid prepared by mixing the fluorescent substance and the radical polymerization initiator to polymerization in a container such as a flask.

The radical polymerization initiator is preferably an organic peroxide such as lauroyl peroxide, and in the case that lauroyl peroxide is used, polymerization may be preferably performed in a range of from 50°C to 60°C.

(Step of Obtaining Wavelength-converting resin composition)

The wavelength-converting resin composition can be produced by mixing the obtained wavelength-converting fluorescent material with a transparent dispersion medium resin.

The conditions for mixing may be appropriately selected in accordance with the wavelength-converting fluorescent material and the dispersion medium resin. For example, a roll mill can be used in a case which an ethylene-vinyl acetate copolymer is used as the transparent dispersion medium resin. Specifically, the resin composition may be obtained by introducing, into a roll mill that has been adjusted to 90°C, an ethylene-vinyl acetate copolymer which is in a pellet form or a powder form and the wavelength-converting fluorescent material, and may further introducing a radical polymerization initiator, a silane coupling agent, and other additives as necessary, and kneading the mixture.

The wavelength-converting resin composition of the invention obtained as described above can be used as a light transmitting layer of a photovoltaic cell module. There is no particular limitation on the form of the wavelength-converting resin composition, while it is preferable to form the resin composition into a sheet shape in view of the ease of use. The resin composition may be made into a sheet shape by a press machine that has been adjusted to 90°C via a spacer. A sheet-shaped wavelength-converting resin composition that is easy to use may be obtained by setting the thickness of the spacer to about 0.4 to 1.0 mm.

The surface of the sheet may be subjected to embossing processing. Inclusion of bubbles may be reduced in a production process of a photovoltaic cell module by subjecting the surface of the sheet to embossing processing.

The wavelength-converting resin composition obtained as described above may be formed into a cast film shape and adhered onto the inner side of a photovoltaic cell or a protective glass so as to configure at least one layer of light transmitting layers of a photovoltaic cell module.

The wavelength-converting resin composition to be used as the cast film may be obtained by appropriately incorporating a cross-linkable monomer and a photo- or thermal- polymerization initiator into an acrylic resin polymerized in a solution of toluene or the like, and mixing the wavelength-converting fluorescent material therewith.

This mixture liquid of the wavelength-converting resin composition is applied on a film which serves as a substrate (such as a PET film) using an applicator or the like and the solvent is dried to obtain the cast film.

The wavelength-converting resin composition of the invention may be used as one light transmitting layer of a photovoltaic cell module having plural light transmitting layers.

A photovoltaic cell module is composed of essential members such as, for example, an antireflective film, a protective glass, a sealant, a photovoltaic cell, a back film, cell electrodes, and a tab line. Among these members, examples of the light transmitting layer having light transmissibility include an antireflective film, a protective glass, a sealant, and a $SiN_x$:H layer and a Si layer of a photovoltaic cell.

The wavelength-converting resin composition of the invention is preferably used as a sealant among the light transmitting layers. It is also possible that the wavelength-converting resin composition is disposed as a wavelength-converting film between a protective glass and a sealant, or between a sealant and a photovoltaic cell.

In a case in which the wavelength-converting resin composition is used as a light transmitting layer, the transparent dispersion medium resin preferably have a refractivity that is at least approximately the same as or higher than that of the layers on the incident side.

More specifically, when the plural light transmitting layers are designated as layer 1, layer 2, ... , and layer m from the light incidence side, and the refractive indices of these layers are designated as $n_1$, $n_2$, ... , and $n_m$, it is preferable that the relationship of $n_1 \leq n_2 \leq ... \leq n_m$ is established.

In the invention, the light transmitting layers listed above is usually provided so that an antireflective film which may be formed as necessary, a protective glass, a sealant and a $SiN_x$:H layer and a Si layer of a photovoltaic cell are layered in this order from the light-receiving surface side of the photovoltaic cell module.

That is, in a case in which the wavelength-converting resin composition of the invention is used as a sealant, in order to make external light that enters from a light-receiving side to be introduced efficiently into a photovoltaic cell with less reflection loss, it is preferable that the refractive index of the wavelength-converting resin composition be higher than the refractive indices of the light transmitting layers disposed closer to the light incidence side than the wavelength-converting resin composition, namely, an antireflective film, a protective glass and the like, and be lower than the refractive indices of the light transmitting layers that are disposed closer to the counter-light incidence side of the sealant formed from the wavelength-converting resin composition of the invention, namely, a $SiN_x$:H layer (also called a "cell antireflective film") and a Si layer of the photovoltaic cell.

When the wavelength-converting resin composition of the invention is used as a sealant, it is disposed on the light-receiving surface of a photovoltaic cell. In this manner, the resin composition can conform to the concavo-convex shape of the light-receiving surface of the photovoltaic cell including a textured structure, cell electrodes, tab lines and the like, without any voids.

<Photovoltaic cell module>

The photovoltaic cell module of the invention is characterized by comprising a light transmission layer including the wavelength-converting resin composition. An excellent conversion efficiency may be achieved thereby.

The photovoltaic cell module may be produced by using, as a wavelength-converting sealant or the like which is provided between a photovoltaic cell and a protective glass, a sheet-shaped resin composition layer which is obtained by using the wavelength-converting resin composition of the invention.

Specifically, the photovoltaic cell module of the invention may be produced by following to a usual production method of a crystalline silicone photovoltaic cell module while using a layer formed of the wavelength-converting resin composition (particularly preferably having a sheet-shape) in place of a usual sealant sheet.

In general, in a crystalline silicone photovoltaic cell module, a sheet-shaped sealant (, which is made to be thermosetting by applying a thermoradical polymerization initiator to an ethylene-vinyl acetate copolymer in many cases,) is first mounted on a cover glass which is a light-receiving surface. In the invention, the wavelength-converting resin composition of the invention is herein used as the sealant. Next, a cell connected with a tab line is mounted thereon, and a sheet-shaped sealant is further mounted thereon (note that it is enough in the invention as long as the wavelength-converting resin composition is used on the light-receiving surface side. This opposite surface may have a conventional sealant). A back sheet is further mounted thereon, and the assembly is processed into a module using a vacuum press laminator for exclusive use for photovoltaic cell modules.

At this time, a temperature of a hot plate of the laminator is set to a temperature required for the sealant to soften, melt, encapsulate the cell, and cure, and the sealant is designed so as to undergo these physical changes and chemical changes usually in a range of from 120°C to 180°C, and in many cases in a range of from 140°C to 160°C.

The wavelength-converting resin composition of the invention is in a state prior to being processed into a photovoltaic cell module, and is specifically in a semi-cured state in a case in which a curable resin is used. The difference between the refractive index of a layer formed from the wavelength-converting resin composition in a semi-cured state and the refractive index of the layer after being cured (after being processed into a photovoltaic cell module) is not very large.

In the case of using the wavelength-converting resin composition in a cast film form, the cast film is first laminated on the counter-light incidence surface of the protective glass or on the light incidence surface of the photovoltaic cell using a vacuum laminator, and a substrate film is removed. If the resin composition is photo-curable, the resin composition is cured by light irradiation. If the resin composition is thermosetting, curing is performed by applying heat, although the curing can be performed by applying heat simultaneously when lamination is performed. The subsequent processes may be carried out by following to a usual method for producing a photovoltaic cell module.

<Method for Evaluating Wavelength-converting resin composition>

A method for evaluating a wavelength-converting resin composition for a photovoltaic cell of the invention includes, with the wavelength-converting resin composition comprising the fluorescent substance and the dispersion medium, evaluating a wavelength conversion efficiency based on a value of $A_1 (\lambda)$, which is represented by the following Equation 1, at a maximum absorption wavelength $\lambda_{max}$ (nm), in a case in which: an intensity of transmitted light that is obtained as a result of incident light having a light intensity of $I_0 (\lambda)$ at a wavelength $\lambda$ (nm) having passed through a resin film in a thickness direction of the resin film being formed from the resin composition and has a thickness of t ($\mu$m), is defined as I ($\lambda$); and an intensity of transmitted light that is obtained as a result of the incident light having passed through a reference resin film in the thickness direction of the reference resin film, the reference resin film being formed from a reference resin composition obtained by excluding the fluorescent substance and the resin particles from the resin composition, and having a thickness of $t_{ref}$ ($\mu$m), is defined as $I_{ref} (\lambda)$.

$$\text{Equation 1:} \qquad A_1(\lambda) = \{\log(I_0(\lambda)/I(\lambda))\}/t - \log\{(I_0(\lambda)/I_{ref}(\lambda))\}/t_{ref}$$

In the invention, a wavelength conversion efficiency of a wavelength-converting resin composition for a photovoltaic cell is evaluated based on the value of $A_1 (\lambda)$. Specifically, a predetermined reference value and the value of $A_1 (\lambda)$ are compared, and in a case in which the value of $A_1 (\lambda)$ is equal to or less than the reference value, it is decided as being excellent in the wavelength conversion efficiency. In the invention, the reference value may be set to, for example, $3.0 \times 10^{-4}$ (O. D. /$\mu$m), and is preferably $2.5 \times 10^{-4}$ (O. D. /$\mu$m) and more preferably $2.0 \times 10^{-4}$ (O. D. /$\mu$m). A screening of a wavelength-converting resin composition for a photovoltaic cell having excellent conversion efficiency can be performed by evaluating the wavelength conversion efficiency of a wavelength-converting resin composition for a photovoltaic cell by this evaluation method without actually configuring a photovoltaic cell. Details of the $A_1 (\lambda)$ are as described above.

The disclosure of Japanese Patent Application No.2010-090350 is incorporated by reference herein. All publications, patent applications, and technical standards mentioned in this specification are herein incorporated by reference to the same extent as if such individual publication, patent application, or technical standard was specifically and individually indicated to be incorporated by reference.

EXAMPLES

The invention will now be described in detail by way of examples thereof, although the invention is not restricted to these examples. It is noted here that "part(s)" and "%" are by mass unless otherwise specified.

<Synthesis of Fluorescent substance>

200 mg of 4,4,4-trifluoro-1-(thienyl)-1,3-butanedione (TTA) was dissolved in 7 ml of ethanol, and 1.1 ml of a 1 M sodium hydroxide solution was added thereto and mixed, and a mixture solution was obtained. 6.2 mg of 1,10-phenanthroline dissolved in 7 ml of ethanol was added to the mixture solution, and the resulting mixture was stirred for one hour. Subsequently, an aqueous solution formed by adding of 103 mg of $EuCl_3 \cdot 6H_2O$ to 3.5 ml of water was added thereto, and a precipitate was obtained. The precipitate was separated by filtration, washed with ethanol, and dried, and thus the fluorescent substance $Eu(TTA)_3Phen$ was obtained.

<Production of Wavelength-converting fluorescent material: 1. Suspension polymerization>

0.5 parts of $Eu(TTA)_3Phen$ obtained above as a fluorescent substance, 100 parts of methyl methacrylate as a vinyl compound, 0.2 parts of lauroyl peroxide as a radical polymerization initiator, and 0.1 parts of n-octanethiol as a chain transfer agent are mixed and stirred to prepare a monomer mixture liquid.
On the other hand, 0.036 parts of polyvinyl alcohol as a surfactant was added to 500 parts of ion-exchanged water, and the monomer mixture liquid was further added thereto. The resulting mixture was vigorously mixed by a homogenizer. A resulted suspension liquid was maintained at 60°C while stirred by using a reflux tube and a flask under nitrogen gas stream to carry out suspension polymerization, and finally a temperature thereof was raised to 90°C to complete the polymerization reaction.
The wavelength-converting fluorescent material obtained herein was in a particulate form having an average particle diameter of about 100 $\mu$m. It was separated by filtration and dried, and sieved as necessary, and thus the wavelength-converting fluorescent material was obtained.
The average particle diameter of the wavelength-converting fluorescent material was measured in terms of a volume-average particle diameter by using water as a dispersion medium and LS 13320 manufactured by Beckman Coulter Inc. as a particle size distribution analyzer.

<Production of Wavelength-converting fluorescent material: 2. Emulsion polymerization>

0.3 parts of $Eu(TTA)_3Phen$ obtained above as a fluorescent substance, 60 parts of methyl methacrylate as a vinyl compound, and 0.012 parts of n-octanethiol as a chain transfer agent are mixed and stirred to prepare a monomer mixture liquid.
On the other hand, 3.65 parts of sodium alkylbenzenesulfonate as a surfactant (G-15 manufactured by Kao Corporation) was added to 300 parts of ion-exchanged water, and the monomer mixture liquid was further added thereto. The resulting mixture was maintained at 60°C while stirred by using a reflux tube and a flask under nitrogen gas stream, and 0.03 pars of potassium peroxymonosulfate as a radical polymerization initiator was added thereto to carry out emulsion polymerization for 4 hours. Finally a temperature thereof was raised to 90°C to complete the polymerization reaction.
The wavelength-converting fluorescent material obtained herein was in a particulate form having a primary average particle diameter of about 100 $\mu$m. It was appropriately subjected to a post treatment using isopropyl alcohol or the like, separated by filtration and dried, and sieved as necessary, and thus the wavelength-converting fluorescent material was obtained.

(Examples 1-22)

<Preparation of Wavelength-converting resin composition>

100 parts an ethylene-vinyl acetate resin (NM30PW manufactured by Tosoh Corporation) as a transparent dispersion medium resin, 1.5 parts of a peroxide thermoradical polymerization initiator LUPEROX 101 (manufactured by Arkema Yoshitomi, Ltd. and herein also works as a cross-linking agent), 0.5 parts of a silane coupling agent SZ 6030 (manufactured by Dow Corning Toray Co., Ltd.), and the polymerized wavelength-converting resin material obtained as above, the kind and amount of which being appropriately varied as shown in the following Table 1 (1 part of the wavelength-converting fluorescent material corresponds to 0.005 parts of a fluorescent substance), were mixed and kneaded in a roll mill regulated to be at 90°C to result in respective fluorescent compositions for wavelength-conversion.

<Production of Wavelength-converting sealant sheet using Resin composition for wavelength-conversion>

The resin composition for wavelength-converting obtained as described above was sandwiched between release sheets and formed to have a sheet shape using a stainless steel spacer and a press having the hot plate adjusted to 90°C. Thus, wavelength-converting sealant sheets having appropriately varied thickness were obtained.

<Preparation of Sample for evaluation>

The wavelength-converting sealant sheets obtained as above were placed on a glass plate, and a PET film was put thereon. Samples for evaluation were prepared by using a vacuum pressure laminator for a photovoltaic cell (LM-50x50-S, manufactured by NPC Inc.) with conditions that the temperature of a hot plate being 150°C, the time of vacuuming being 10 minutes, and the pressuring time being 15 minutes.

<Evaluation of Loss of Light within excitation wavelength range: 1>

The sample for evaluation obtained as above was placed on a detection unit of a solar simulator grating spectroradiometer LS-100 manufactured by Eko Instruments Co., Ltd. and radiation was provided thereto by using the solar simulator WXS-1555-10, AM 1.5G manufactured by Wacom Electric Co., Ltd. to obtain the intensity spectrum $I(\lambda)$. Further, the intensity spectrum of blank, $I_0(\lambda)$, was obtained with placing nothing on the detection unit of the LS-100. Further, a reference sample prepared following to the preparation of the sample for evaluation without using the wavelength-converting fluorescent material was placed on the detection unit of the LS-100, and the intensity spectrum of the reference sample, $I_{ref}(\lambda)$, was obtained.

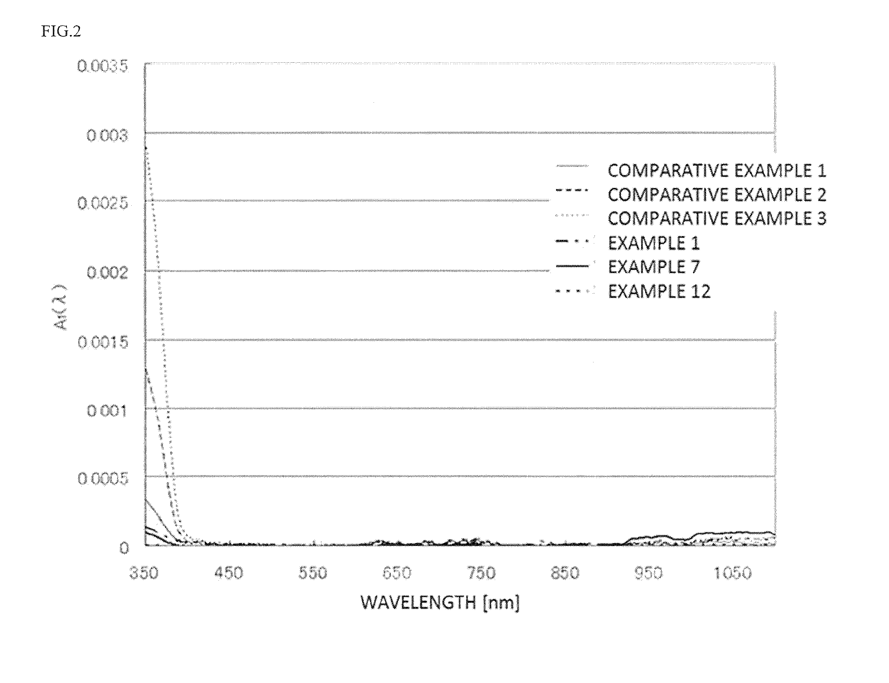

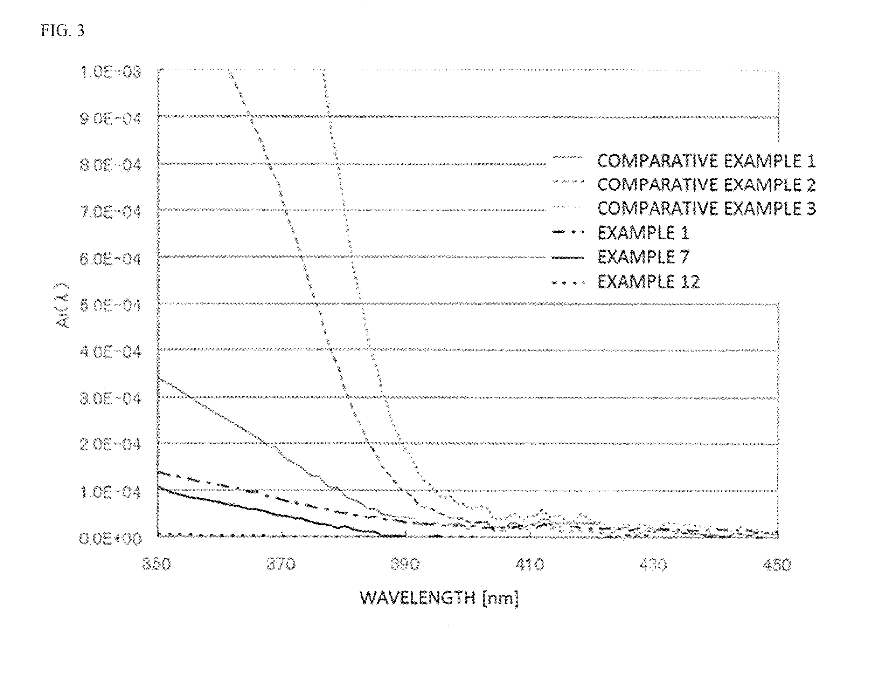

The thickness of the sample for evaluation and the reference sample, $t$ and $t_{ref}$, were respectively obtained by measuring a thickness of the thickest portion of the sample for evaluation and the reference sample by using a digital micrometer and subtracting the thicknesses of the glass and the PET film. The spectra of $A_1(\lambda)$ were obtained according to the following equation. Figs. 2 and 3 show one example of the spectra of the obtained $A_1(\lambda)$. Fig. 3 is an enlarged view of a part of Fig. 2.

$$A_1(\lambda) = \{\log(I_0(\lambda)/I(\lambda))\}/t - \log\{(I_0(\lambda)/I_{ref}(\lambda))\}/t_{ref}$$

<Confirmation of Excitation wavelength range>

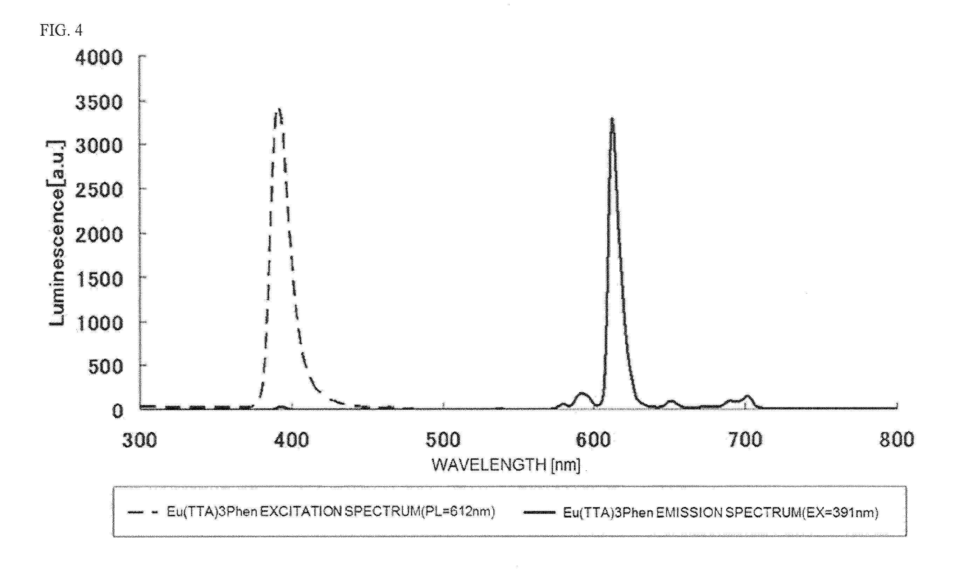

An excitation spectrum was measured with respect to a fluorescent substance solution in which the fluorescent substance obtained as above was dissolved in isopropyl alcohol by using a fluorescence spectrophotometer F-4500 manufactured by Hitachi High-Technologies Corporation. One example of the excitation spectrum is shown in Fig. 4.

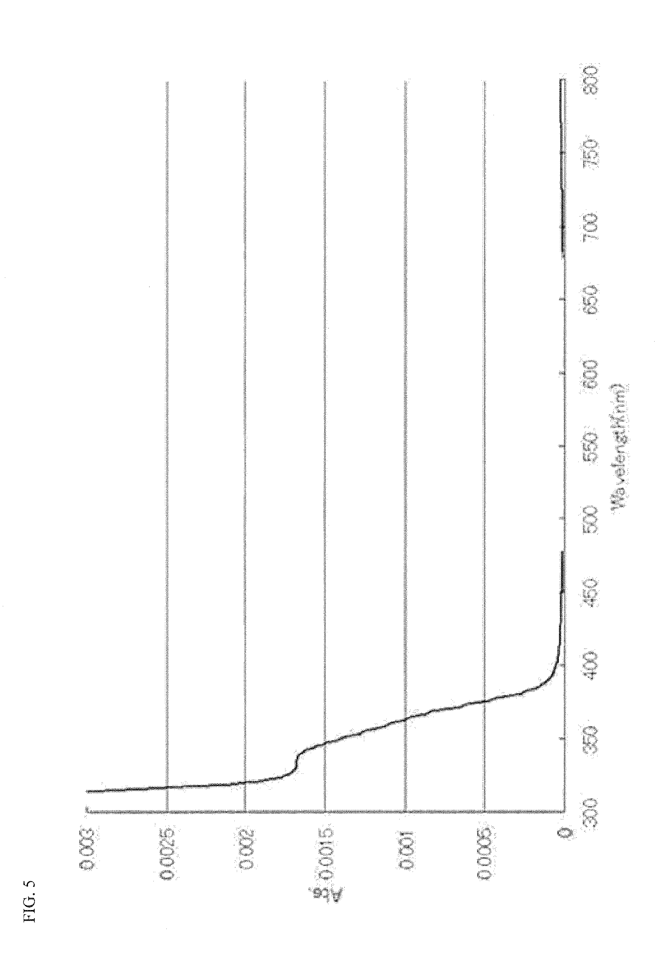

Further, an absorbance spectrum was measured with respect to the wavelength-converting sealant sheet containing the fluorescent substance by using a spectrophotometer V-570 manufactured by JASCO Corporation. One example of the absorbance spectrum is shown in Fig. 5.

In these figures, the excitation peak wavelength, which is around 390 nm, is shifted from the absorption peak wavelength, which is around 350 nm. Accordingly, evaluations of Examples and Comparative examples were performed based on the values of $A_1(\lambda)$ at the maximum absorption wavelength 350 nm.

The absorbance threshold at which an absorbance per film thickness in the absorbance spectrum becomes $1.0 \times 10^{-4}$ (O. D. /$\mu$m) or less is around 400 nm. Accordingly, evaluations were also performed with respect to average values of the $A_1(\lambda)$ in a range of from 350 to 450 nm.

The $A_1(\lambda)$ at 350 nm and the average values of $A_1(\lambda)$ in 350-400 nm are shown in Table 1.

<Evaluation of Photovoltaic cell module>

A conductive film for a photovoltaic cell CF-105 manufactured by Hitachi Chemical Co., Ltd. was applied to a crystalline silicone photovoltaic cell, tab lines are connected thereto by using a crimping apparatus for exclusive use so that two lines (thickness: 0.14 mm, width: 2 mm, plated with zinc) connect at the upper surface and two lines connect at the back surface, and the each of the tab lines in the upper surface and the back surface are made into outside electric wires using a side tab line (A-TPS 0.23×6.0, manufactured by Hitachi Cable, Ltd.). The I-V characteristics of the photovoltaic cell was obtained according to JIS-C-8914 by using a solar simulator WXS-155S-10, AM 1.5G manufactured by Wacom Electric Co., Ltd. and an I-V curve tracer MP-160 manufactured by Eko Instruments Co., Ltd..

Further, a photovoltaic cell module for evaluation was produced by using the crystalline silicone photovoltaic cell to which tab lines are connected by disposing a cover glass manufactured by Asahi Glass Co., Ltd., the wavelength-converting sealant (EVA) sheet obtained in the <Production of Wavelength-converting sealant sheet using Resin composition for wavelength-conversion>, the photovoltaic cell, an EVA sheet for backside (fluorescent material-free), and a PET film (TOYOBO ESTER FILM A4300 manufactured by Toyobo Co., Ltd.) in this order from the lower side, and using a vacuum pressure laminator for photovoltaic cells (LM-50x50-S, manufactured by NPC Inc.) with conditions that the temperature of a hot plate being 150°C, the time of vacuuming being 10 minutes, and the pressuring time being 15 minutes. The I-V characteristics was obtained with respect to the photovoltaic cell module for evaluation in the similar manner as described above. Results obtained therefrom are summarized in Table 1.

Among various measurement values, with respect to Jsc (short-circuit current density), $\Delta$Jsc calculated by the following equation was used to evaluate the photovoltaic cell module for evaluation.

$$\Delta \mathrm{Jsc} = \mathrm{Jsc\ (module)} - \mathrm{Jsc\ (cell)}$$

Note that the measurement for the evaluation was herein performed without using a UV filter of the solar simulators.

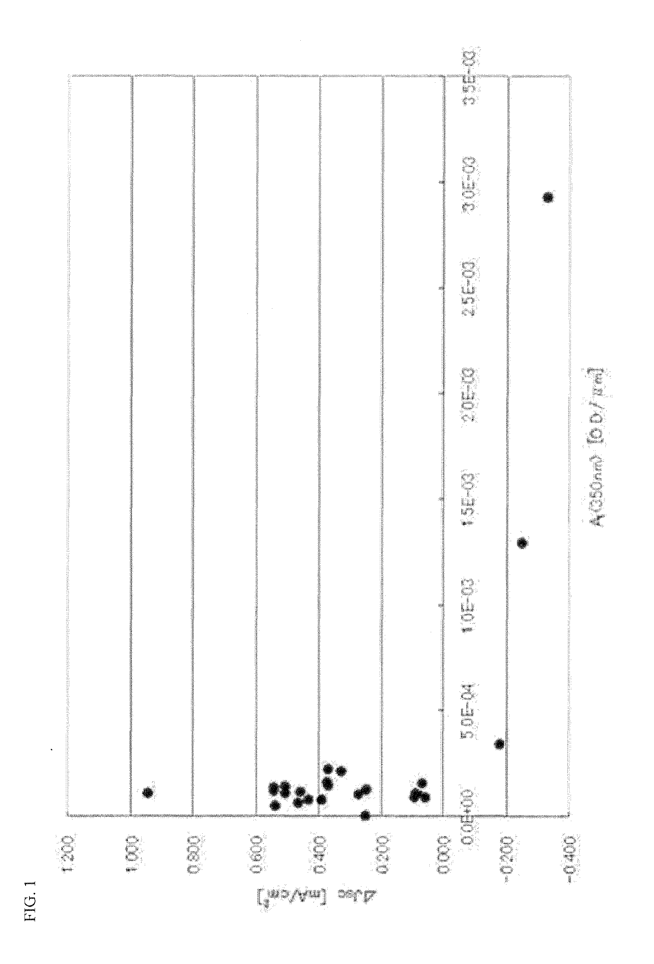

Further, the relationship between the $\Delta$Jsc and the $A_1$ ($\lambda$) at 350 nm is shown in Fig. 1.

It is understood from these figures that the wavelength conversion effect in a photovoltaic cell is lost when the value of $A_1$ ($\lambda_{max}$) become large.

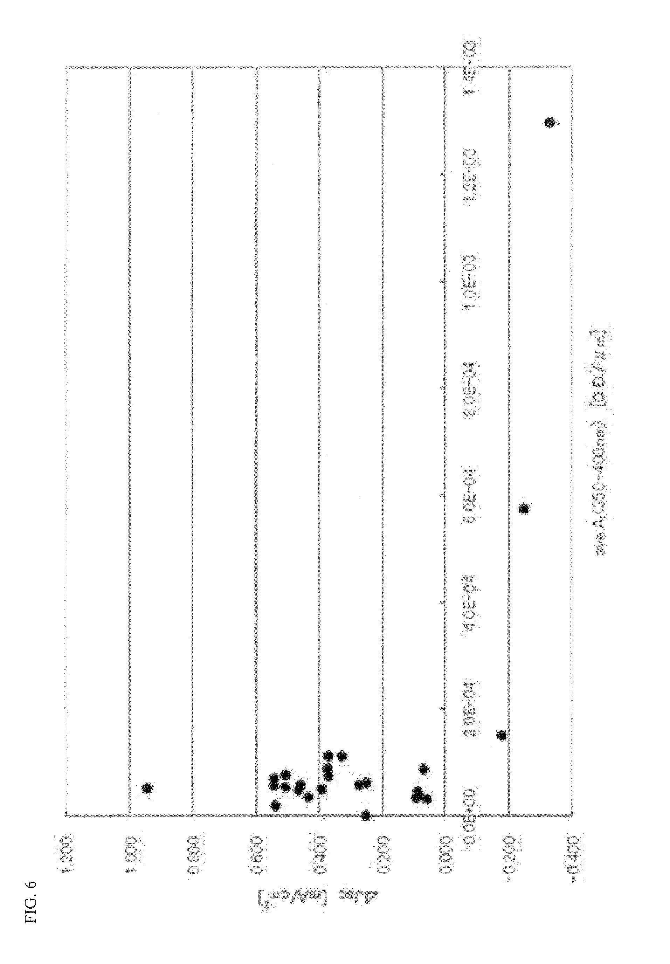

Furthermore, the relationship between the $\Delta$Jsc and the average value of $A_1$ (350-400 nm) is shown in Fig. 6. It is understood from these figures that the wavelength conversion effect in a photovoltaic cell is lost when the average value of $A_1$ (350-400 nm) become large.

(Comparative examples 1-3)

Resin compositions for wavelength-conversion were obtained in the similar manner as described for Examples 1-22 in the <Preparation of Wavelength-converting resin composition>, except that the fluorescent substance itself obtained as described above was used in place of the wavelength-converting fluorescent material and the addition amounts thereof were appropriately changed so that the contents thereof become those shown in Table 1.

The values of $A_1$ ($\lambda$) were calculated with respect to the obtained resin composition for wavelength-conversion in the similar manner as described above.

Further, photovoltaic cell modules for evaluation were prepared and evaluated for the performance in the similar manner as described above. Results are summarized in Table 1.

Table 1

| | Resin sealing method | Mesh size of Sieve | Concentration of Eu complex | ΔJsc | Integrated emission intensity | In-line transmittance (PT) | Thickness of Sample for evaluation | $\log_{10}PT/t$ | System: LS-100 | |
|---|---|---|---|---|---|---|---|---|---|---|
| | | | | | | | | | $A_1$(350nm) | Ave. $A_1$ (350 to 400nm) |
| | | μm | parts by mass | mA/cm$^2$ | arb. unit | % | μm | /μm | OD/μm | OD/μm |
| Example 1 | E.P. | No sieving | 0.01 | 0.538 | 4.00E+13 | 87.59 | 539 | 3.60 E-03 | 1.40E-04 | 7.30E-05 |
| Example 2 | E.P. | No sieving | 0.01 | 0.942 | 4.60E+13 | 87.59 | 368 | 5.30E-03 | 1.10E-04 | 5.40E-05 |
| Example 3 | E.P. | No sieving | 0.02 | 0.067 | 2.30E+13 | 87.11 | 371 | 5.20E-03 | 1.60E-04 | 8.70E-05 |
| Example 4 | E.P. | ≤25 | 0.01 | 0.09 | 4.40E+13 | 88.2 | 596 | 3.30E-03 | 9.10E-05 | 3.50E-05 |
| Example 5 | E.P. | 25-53 | 0.01 | 0.087 | 4.40E+13 | 87.95 | 623 | 3.10E-03 | 1.10E-04 | 4.70E-05 |
| Example 6 | E.P. | 53-425 | 0.01 | 0.055 | 4.60E+13 | 87.3 | 585 | 3.30E-03 | 9.20E-05 | 3.30E-05 |
| Example 7 | E.P. | ≥425 | 0.01 | 0.08 | 4.80E+13 | 89.8 | 522 | 3.70E-03 | 1.10E-04 | 3.90E-05 |
| Examples 8 | E.P. | 53-425 | 0,001 | 0.327 | 2.40E+13 | 85.99 | 188 | 1.00E-02 | 2.10E-04 | 1.10E-04 |
| Example 9 | E.P. | 53-425 | 0.0025 | 0.538 | 3.70E+13 | 89.06 | 308 | 6.30E-03 | 1.20E-04 | 5.70E-05 |
| Example 10 | E.P. | 53-425 | 0.005 | 0.505 | 3.40E+13 | 88.59 | 323 | 6.00E-03 | 1.40E-04 | 7.70E-05 |
| Example 11 | E.P. | 53-425 | 0.02 | 0.37 | 3.30E+13 | 84.82 | 305 | 6.30E-03 | 2.20E-04 | 1.10E-04 |
| Example 12 | S.P. | No sieving | 0.01 | 0.249 | 4.80E+13 | 88.03 | 1081 | 1.80E-03 | 6.40E-06 | 2.00E-06 |
| Example 13 | S.P. | No sieving | 0.01 | 0.462 | 8.00E+13 | 87.85 | 967 | 2.00E-03 | 6.50E-05 | 4.80E-05 |
| Example 14 | S.P. | No sieving | 0.01 | 0.391 | 4.40E+13 | 88.06 | 545 | 3.60E-03 | 8.20E-05 | 5.00E-05 |
| Example 15 | S.P. | ≤150 | 0.01 | 0.369 | 3.00E+13 | 86.65 | 352 | 5.50E-03 | 1.50E-04 | 7.50E-05 |
| Example 16 | S.P. | 150-250 | 0.01 | 0.455 | 2.60E+13 | 87.55 | 317 | 6.10E-03 | 1.20E-04 | 6.00E-05 |
| Example 17 | S.P. | 250-425 | 0.01 | 0.431 | 2.50E+13 | 87.53 | 379 | 5.10E-03 | 8.00E-05 | 3.80E-05 |
| Example 18 | S.P. | ≥425 | 0.01 | 0.536 | 2.50E+13 | 87.94 | 443 | 4.40E-03 | 5.00E-05 | 2.10E-05 |
| Example 19 | S.P. | No sieving | 0.001 | 0.247 | 2.90E+13 | 85.76 | 267 | 7.20E-03 | 1.30E-04 | 6.30E-05 |
| Example 20 | S.P. | No sieving | 0.0025 | 0.504 | 3.50E+13 | 87.34 | 314 | 6.20E-03 | 1.10E-04 | 5.60E-05 |
| Example 21 | S.P. | No sieving | 0.005 | 0.273 | 4.40E+13 | 86.99 | 402 | 4.80E-03 | 1.10E-04 | 5.90E-05 |
| Example 22 | S.P. | No sieving | 0.02 | 0.373 | 1.10E+14 | 84.46 | 325 | 5.90E-03 | 1.60E-04 | 9.00E-05 |

EP 2 557 600 A1

(continued)

| | Resin sealing method | Mesh size of Sieve | Concentration of Eu complex | ΔJsc | Integrated emission intensity | In-line transmittance (PT) | Thickness of Sample for evaluation | $\log_{10} PT/t$ | System: LS-100 | |
|---|---|---|---|---|---|---|---|---|---|---|
| | | | | | | | | | $A_1$(350nm) | Ave. $A_1$ (350 to 400nm) |
| | | μm | parts by mass | mA/cm$^2$ | arb. unit | % | μm | /μm | OD/μm | OD/μm |
| Comp.ex.1 | - | - | 0.01 | -0.18 | 3.30E+13 | 88.02 | 349 | 5.60E-03 | 3.40E-04 | 1.50E-04 |
| Comp.ex.2 | - | - | 0.04 | -0.25 | 7.50E+13 | 89.47 | 386 | 5.10E-03 | 1.30E-03 | 5.80E-04 |
| Comp.ex.3 | - | - | 0.08 | -0.33 | 1.20E+14 | 88.32 | 313 | 6.20E-03 | 2.90E-03 | 1.30E-03 |

Comp.ex. : Comparative example
E.P. : Emulsion polymerization
S.P. : Suspension polymerization

<Evaluation of In-line transmittance in Visible region>

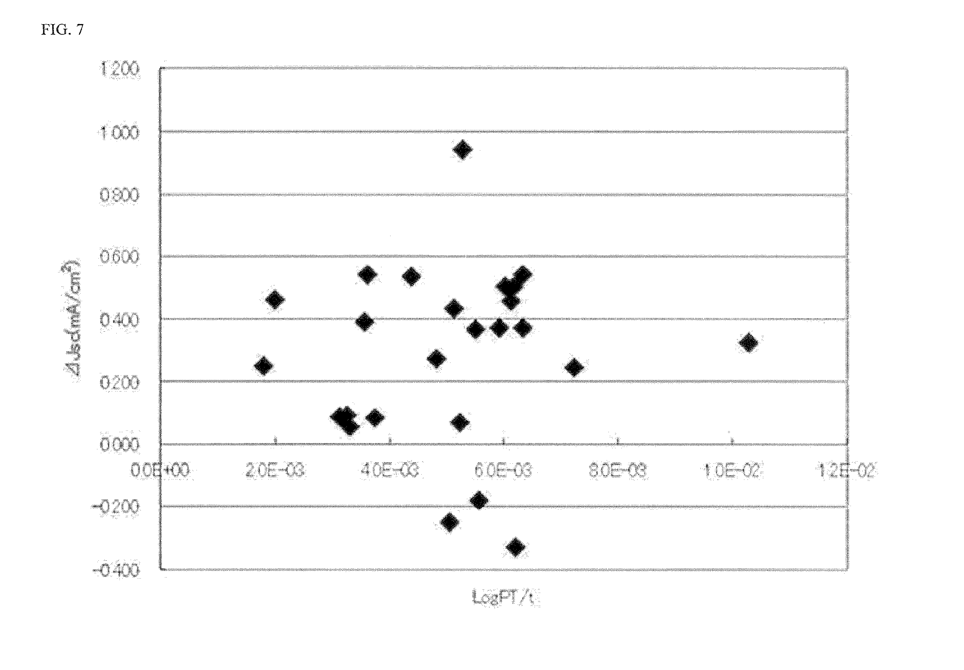

The in-line transmittances (PT) in the visible region were measured with respect to the samples for evaluation of Examples and Comparative examples obtained as above by using a haze meter (NDH-2000, manufactured by Nippon Denshoku Industries Co., Ltd.), common logarithms thereof were divided by the thickness of the samples for evaluation, and normalized by the film thickness to provide an index $\log_{10}PT/t$.
Results thereof are summarized in Fig. 7. It is understood from Fig. 7 that there is no particular relationship between the index $\log_{10}PT/t$ and the $\Delta$Jsc, and thus the transmittance in the visible region is insufficient for expressing the wavelength-conversion effect of a photovoltaic cell.

<Evaluation of Emission intensity>

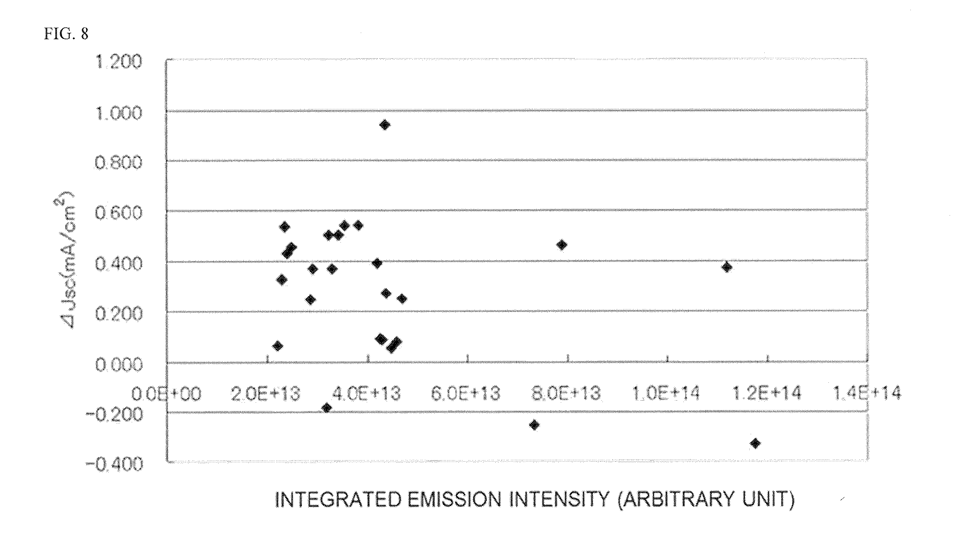

The integrated emission intensities were measured with respect to the samples for evaluation of Examples and Comparative examples obtained as above by using a quantum efficiency measurement system (QEMS-2000 manufactured by Systems Engineering Inc.).
Results thereof are summarized in Fig. 8. It is understood from Fig. 8 that there is no particular relationship between the integrated emission intensity and the $\Delta$Jsc, and thus the integrated emission intensity is insufficient for expressing the wavelength-conversion effect of a photovoltaic cell.

INDUSTRIAL APPLICABILITY

According to the invention, it is possible to provide a resin composition for wavelength-conversion capable of converting light that contributes less to photovoltaic power generation in the incident solar radiation to a wavelength that contributes significantly to power generation, as well as capable of utilizing the solar radiation efficiently and stably without deteriorating, when the fluorescent substance for wavelength-conversion and the resin composition for wavelength-conversion are applied to a photovoltaic cell module.

**Claims**

1. A wavelength-converting resin composition for a photovoltaic cell, comprising: a fluorescent substance having a maximum absorption wavelength in an absorbance spectrum of $\lambda_{max}$ (nm); resin particles; and a dispersion medium resin,
   wherein a value of $A_1 (\lambda)$, which is represented by the following Equation 1, at the maximum absorption wavelength $\lambda_{max}$ (nm) is $3.0 \times 10^{-4}$ (O. D. /$\mu$m) or less in a case in which:

   an intensity of transmitted light that is obtained as a result of incident light having a light intensity of $I_0 (\lambda)$ at a wavelength $\lambda$, (nm) having passed through a resin film in a thickness direction of the resin film, the resin film being formed from the resin composition and having a thickness of t ($\mu$m), is defined as $I (\lambda)$; and
   an intensity of transmitted light that is obtained as a result of the incident light having passed through a reference resin film in a thickness direction of the reference resin film, the reference resin film being formed from a reference resin composition obtained by excluding the fluorescent substance and the resin particles from the resin composition, and having a thickness of $t_{ref}$ ($\mu$m), is defined as $I_{ref} (\lambda)$:

$$\text{Equation 1:} \qquad A_1(\lambda) = \{\log(I_0(\lambda)/I(\lambda))\}/t - \log\{(I_0(\lambda)/I_{ref}(\lambda))\}/t_{ref} .$$

2. The wavelength-converting resin composition for a photovoltaic cell of claim 1, wherein the fluorescent substance is encapsulated in the resin particles.

3. The wavelength-converting resin composition for a photovoltaic cell of claim 1 or claim 2, wherein the fluorescent substance is a rare earth complex comprising an organic ligand.

4. A photovoltaic cell module, comprising a light transmitting layer including the wavelength-converting resin composition for a photovoltaic cell of any one of claims 1 to 3.

5. A method for evaluating a wavelength-converting resin composition for a photovoltaic cell, the method comprising evaluating a wavelength conversion efficiency based on a value of $A_1 (\lambda)$, which is represented by the following Equation 1, at a maximum absorption wavelength $\lambda_{max}$ (nm), in a case in which:

an intensity of transmitted light that is obtained as a result of incident light having a light intensity of $I_0 (\lambda)$ at a wavelength $\lambda$ (nm) having passed through a resin film in a thickness direction of the resin film, the resin film being formed from the resin composition and having a thickness of t ($\mu$m), is defined as $I (\lambda)$; and
an intensity of transmitted light that is obtained as a result of the incident light having passed through a reference resin film in the thickness direction of the reference resin film, the reference resin film being formed from a reference resin composition obtained by excluding the fluorescent substance and the resin particles from the resin composition, and having a thickness of $t_{ref}$ ($\mu$m), is defined as $I_{ref} (\lambda)$:

$$\text{Equation 1:} \qquad A_1(\lambda) = \{\log(I_0(\lambda)/I(\lambda))\}/t - \log\{(I_0(\lambda)/I_{ref}(\lambda))\}/t_{ref}.$$

FIG. 1

FIG.2

FIG. 3

FIG. 4

FIG. 5

FIG. 6

ave A<sub>t</sub>(350~400nm) [O.D / μm]

EP 2 557 600 A1

FIG. 7

EP 2 557 600 A1

FIG. 8

EP 2 557 600 A1

| INTERNATIONAL SEARCH REPORT | International application No. |
|---|---|
| | PCT/JP2011/058933 |

A. CLASSIFICATION OF SUBJECT MATTER
*H01L31/042*(2006.01)i, *C09K11/06*(2006.01)i

According to International Patent Classification (IPC) or to both national classification and IPC

B. FIELDS SEARCHED

Minimum documentation searched (classification system followed by classification symbols)
C09K11/00-11/89, H01L31/04-31/06, 51/42

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2010/001703 A1 (Hitachi Chemical Co., Ltd.), 07 January 2010 (07.01.2010), paragraphs [0011], [0012], [0030], [0031], [0098], [0105], [0114] to [0122]; fig. 1 & JP 2010-034502 A | 1-5 |
| Y | JP 2009-249445 A (Mitsubishi Chemical Corp.), 29 October 2009 (29.10.2009), paragraphs [0169], [0170], [0176], [0249] (Family: none) | 1-5 |
| Y | WO 2009/125701 A1 (Toray Industries, Inc.), 15 October 2009 (15.10.2009), paragraphs [0071] to [0073], [0104] (Family: none) | 1-5 |

☐ Further documents are listed in the continuation of Box C. ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 20 April, 2011 (20.04.11) | 10 May, 2011 (10.05.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

32

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000328053 A
- JP 2001352091 A

- JP 2010090350 A

**Non-patent literature cited in the description**

- **MASAYA MITSUISHI ; SHINJI KIKUCHI ; TOKUJI MIYASHITA ; YUTAKA AMANO.** *J. Mater. Chem.,* 2003, vol. 13, 285-2879